(19) Europäisches Patentamt
European Patent Office
Office européen des brevets

(11) **EP 3 316 182 A1**

(12) **EUROPEAN PATENT APPLICATION**

(43) Date of publication:
02.05.2018 Bulletin 2018/18

(51) Int Cl.:
**G06K 19/07** (2006.01)

(21) Application number: 16196132.1

(22) Date of filing: 27.10.2016

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Melexis Technologies SA**
**2022 Bevaix (CH)**

(72) Inventors:
• TEICHMANN, Peter
  99099 Erfurt (DE)
• OTT, Andreas
  99099 Erfurt (DE)

(74) Representative: **DenK iP**
**Leuvensesteenweg 203**
**3190 Boortmeerbeek (BE)**

(54) **METHOD AND DRIVER CIRCUIT FOR RESONANT ANTENNA CIRCUIT**

(57)     A transmitter device comprising a resonant antenna circuit and a driver circuit. The resonant antenna circuit comprises three branches: a first branch with an inductor coil, a second branch with a first capacitance (C1), and a third branch with a second capacitance (C2) connected in series with a first switch (S1). The antenna circuit has a first and second resonance frequency respectively higher and lower than a target frequency, depending on whether the first switch is closed. The driver circuit monitors an oscillating voltage of the antenna circuit, and detects oscillations thereof, for example by detecting zero-crossing moments, and controls the first switch such that, on average, the number of oscillations of the oscillating voltage per time unit is equal to a predefined target frequency (ftarget). A driver circuit. A method of driving said resonant antenna circuit. A method of transmitting a modulated signal.

**FIG 3**

301

## Description

## Field of the invention

The invention relates to the field of resonant circuits, e.g. resonant antenna circuits, and to methods and circuits for driving such resonant circuits, and to a transmitter device containing such a driver circuit and/or performing such a method. The present invention relates in particular to the field of Passive Keyless Entry (PKE) systems and/or Passive Start Entry (PASE) systems.

## Background of the invention

Driver circuits for driving resonant circuits, e.g. passive resonant circuits, are known in the prior art. Resonant circuits can be for example: series LC circuits, parallel LC circuit, series RLC circuit, parallel RLC circuit, just to name a few. They can be used inter alia for transmission of a wireless signal.

Passive keyless entry (PKE) systems (mounted in a vehicle) typically transmit an LF signal (e.g. 125 kHz) to the key (carried by the driver) in order to wake up the key and/or to transfer data to the key. The answer from the key is then usually received at RF (e.g. 433 MHz), due to the better power efficiency and range. The key may also act as a passive transponder, and the answer is then also received as LF signal, however with limited communication range. This is typically used as backup solution in case of an empty battery in the key. It may also be used for the immobilizer that prevents start of the engine without the key. Such keys are commercially available in the market, and newly developed transmitter devices may need to be backwards compatible with such keys.

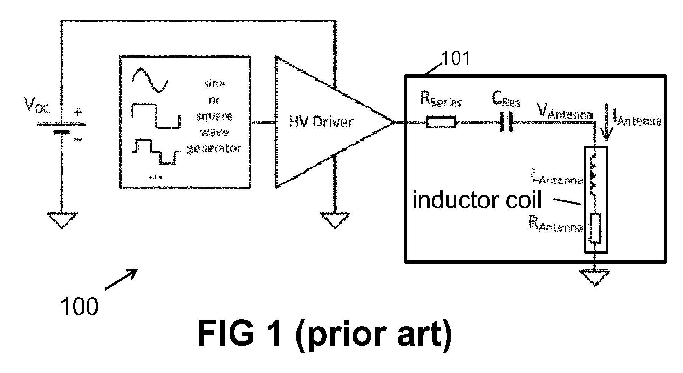

FIG. 1 shows a traditional PKE driver system that uses an antenna in series resonance mode and drives the antenna with a voltage signal. The inductive antenna is connected via a wiring harness to the antenna driver. A resonance capacitor Cres located on the driver side tunes the antenna to the target LF frequency. In the arrangement of FIG. 1, the antenna voltage amplitude is Q times higher than the voltage amplitude of the driver, Q being the "quality factor" of the resonant circuit. The antenna driver must provide the entire antenna current. As can be seen, the resonant circuit does not only have an inductor coil and a resonance capacitor, but also has a discrete resistor Rseries connected in series with the capacitor and the inductor coil. The quality factor of the resonant circuit is limited by by the additional series resistance Rseries, and is typically set to a value between 2.5 and 10. However, the resistor serves several important purposes:

a) defines the antenna current amplitude for a given driver voltage amplitude
b) reduces the impact of antenna detuning e.g. due to metallic surrounding,

c) facilitates the transmission and reception of modulated signals due to the increase of the bandwidth of the antenna resonant circuit.

A wider bandwidth is advantageous for example when the actual resonance frequency slightly deviates from the target frequency, for example due to the presence of metal. Another advantage of the system of FIG. 1 is that it allows to transmit a signal at a predefined frequency, e.g. the frequency of the excitation signal, which may be slightly different from the resonance frequency. Thus a certain amount of tuning the frequency is possible.

A disadvantage of the PKE system of FIG. 1 is that it has a low power efficiency due to the additional series resistance Rseries, which dissipates energy.

It is a challenge to find a circuit and/or method that simultaneously offers both high-energy efficiency, and the ability to transmit at a predefined frequency.

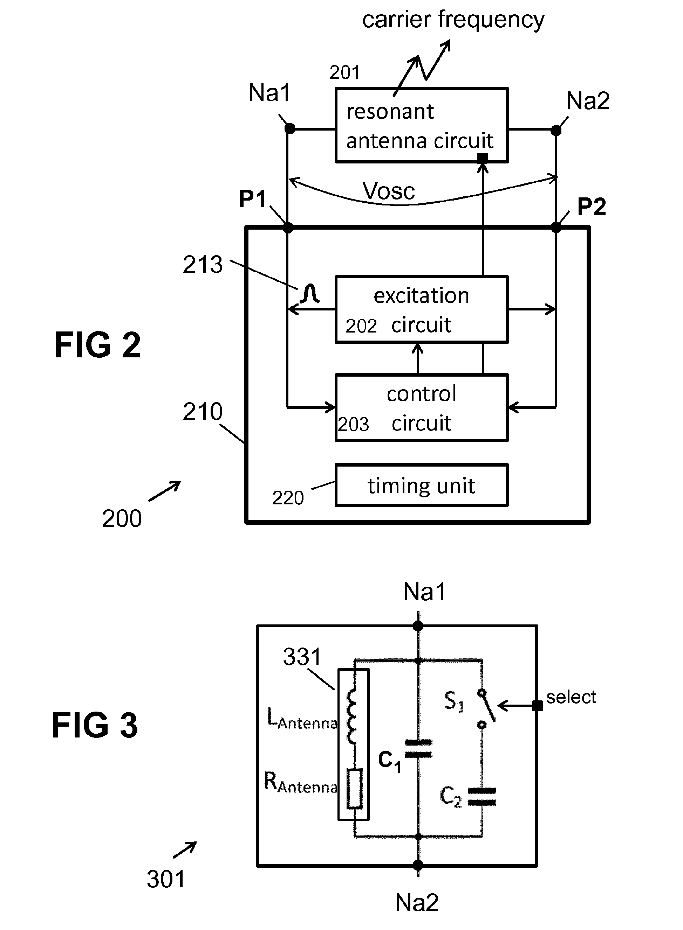

US2016250995(A1) describes a driver circuit for an inductor coil and a method for operating an inductor coil. FIG. 1 and FIG. 2 of said US publication show how control circuit 9 measures the oscillating inductor current using series resistor 8, and controls the switch S1 to recharge the capacitor 4, and controls the switch S2 to start and stop the resonance circuit at the completion of each and every oscillating cycle, and controls switch S3 to discharge the capacitor via diode 11. The resonance frequency F1 is 5% to 30% higher than the carrier frequency. The main principle of operation is based on: (a) closing switch S2 to allow the LRC circuit to perform one complete oscillating cycle, (b) opening the switch S2 after completion of one complete oscillating cycle, (c) closing switch S1 to recharge the capacitor, (d) opening switch S1 and waiting until a given moment, and repeating steps (a) to (d). In this way the timing and thus the ground frequency of the transmitted waveform is imposed.

There is always room for improvements or alternatives.

## Summary of the invention

It is an object of the present invention to provide a transmitter device comprising a resonant antenna circuit and a driver circuit, an antenna circuit, a driver circuit, and a method of driving said antenna circuit, capable of transmitting an electromagnetic signal at a predefined carrier frequency (or more precisely: in a relatively narrow band containing the predefined carrier frequency).

In particular, it is an object of such a transmitter device, driver circuit, antenna circuit and method that they allow to drive the resonant antenna circuit in a manner in which the predefined carrier frequency (or the narrow band containing said carrier frequency) is substantially insensitive to component variations and/or to the presence of metal objects in close vicinity to the circuit, and/or where the spectral behavior in terms of EMC spurious emissions is satisfying the legislated spectrum requirements, and/or where the driver circuit does not significantly increase the resistive losses of the resonant antenna circuit during continuous transmission, and/or wherein the energy efficiency during continuous transmission is improved (as compared to systems where a frequency is imposed upon the resonant circuit, and/or wherein the overall energy efficiency (over periods of continuous transmission and periods of data-communication including periods of radio-silence) is improved, and preferably two or more of these objects.

It is an object of particular embodiments of the present invention to provide such a transmitter device, driver circuit, antenna circuit and method that allow to transmit a modulated data stream, e.g. an ASK or BSP or OOK-modulated bitstream (for example according to, but not limited to the norms ISO/IEC 18000-2 and 18047-2 related to TAG below 135kHz).

It is an object of particular embodiments of the present invention to provide an integrated driver circuit capable of simultaneously driving a plurality of resonant antenna circuits (for example at least 2 or at least 3 or at least 4 or at least 5 or at least 6 resonant antenna circuits) with fewer pins as compared to some prior art solutions.

These and other objectives are accomplished by a method and driver circuit and transmitter device according to embodiments of the present invention.

In a first aspect, the present invention provides a driver circuit connectable to a resonant antenna circuit, the resonant antenna circuit comprising three branches connected in parallel: a first branch comprising an inductor coil; a second branch comprising a first capacitance; a third branch comprising a second capacitance connected in series with a first switch; and wherein the first capacitance is chosen such that the antenna circuit has a first resonance frequency higher than a predefined target frequency if the first switch would be permanently open; and wherein the second capacitance is chosen such that the antenna circuit has a second resonance frequency lower than the target frequency if the first switch would be permanently closed; the driver circuit comprising: monitoring means adapted for monitoring the oscillating voltage signal; means for detecting oscillations of said oscillating voltage signal; a control circuit for dynamically controlling the first switch in such a way that, on average, the number of oscillations of the oscillating voltage over time or per time unit is substantially equal to the target frequency.

With "the number of oscillations per time unit" is meant "the oscillation rate" or "the number of oscillations measured or detected during a given time window divided by the duration of that time window". The absolute duration of said time window is not critical for the present invention to work, and may depend on the actual algorithm used.

The monitoring means may be adapted for monitoring and/or extracting amplitude information and/or timing information and/or phase information of the oscillating voltage.

Driver circuits according to the present invention are especially suitable for passive keyless entry (PKE) systems and/or Passive Start Entry (PASE) systems.

The resonant antenna circuit preferably has a Q-factor of at least 15, or at least 20, or at least 25, or at least 30, or at least 32, or at least 34 or at least 36 or at least 38 or at least 40.

It is an advantage of using a resonant circuit with such a high Q-factor, when allowed to oscillate at its resonance frequencies, that it is very power-efficient (low energy losses), which is important for battery-powered applications.

It is an advantage of dynamically opening and closing the switch such that the number of oscillations in a given time window is substantially equal to the number of oscillations that would occur if the antenna circuit was resonating exactly at the target frequency.

It is an advantage of choosing the value for C1 and C2 such that the first resonance frequency (when the switch is open) is higher than the target frequency and the second resonance frequency (when the switch is closed) is smaller than the target frequency, and of dynamically opening and closing the switch based on a time-averaged value rather than on a predefined fixed ratio, because this allows the circuit to automatically adjust itself under various circumstances, such as for example variations of the inductance and/or the capacitance(s) over time (aging) and/or due to temperature and/or humidity and/or presence of metal, etc. This advantage should not be underestimated, because it allows use of components (L and C) with large tolerances of their characteristic values, and/or allows to reduce or eliminate a calibration step during production, thus savings costs. The time-average value can for example be derived from an independent clock signal.

It is an advantage of measuring a voltage provided by the antenna resonance circuit using the same nodes as the nodes where the excitation signal is injected, because only two nodes are required, in contrast to some prior art solutions, where at least three nodes are required. It is well known in the art of semiconductor industry that the number of pins is an important criterium for selection a package, and that the package cost of an integrated circuit increases with the number of pins. Thus, by requiring less pins, the package cost can be reduced, or for a given package, the number of antenna resonant circuits that can be connected can be increased, or the pin can be used for other functionality.

It is an advantage of embodiments of the present invention that the full antenna current (e.g. 10 Amp-peak-to-peak) is not flowing through the driver circuit, which would increase the requirements on a fully integrated solution regarding power dissipation, thermal budget, and current carrying capabilities (bond wires, on-chip metallization). The driver circuit of the present invention has to cope with the oscillating voltage over the antenna (e.g. in the order of 40 Vpp or 80 Vpp, but these requirements are easier to meet.

In an embodiment, the first branch of the antenna circuit only contains an inductor coil and optionally a series resistor but no switch connected in series with the conductor coil, and the second branch only contains a first capacitor and optionally a series resistor but no switch connected in series with the first capacitor.

It is a major advantage of such embodiments, because the driver circuit does not need to interrupt an ongoing oscillation of the resonant circuit by opening a switch between the inductance and the capacitance when recharging the capacitance. In contrast, the oscillation is not interrupted, and an excitation signal is injected while the oscillation is continuing. This results in a more accurate or more stable resonance frequency, and creates less harmonics by avoiding such interruption.

In an embodiment, the means for detection oscillations of said oscillating voltage comprises means for measuring or determining or extracting amplitude and/or phase information from said oscillating voltage.

In an embodiment, the means for detecting oscillations of said oscillating voltage comprises means for detecting zero-crossing-moments defined as moments in time at which the oscillating voltage crosses a predefined DC level; and the control circuit is adapted for optionally or conditionally opening and closing the first switch at said zero-crossing moments (for example only at said zero crossing moments), and for keeping the first switch open or closed between said zero-crossing moments.

In other words, it is decided whether the switch is to be opened or closed or maintained open or maintained closed, based on the time-averaging criterium, and if it is decided that the switch is to be opened or closed, the actual opening or closing occurs at such a zero-crossing moment.

The predefined DC level can be chosen as the voltage level of the oscillating antenna voltage at which the voltage over the first capacitor (and thus also over the inductance) is zero, which is the voltage level halfway between the minimum and maximum value of the oscillating voltage.

It is an advantage of opening and closing the first switch at appropriate moments in time, in particular at moments in time at which the voltage over the inductance is substantially zero, because these moments in time are relatively easy to detect, and can be detected rather accurately. In addition, by opening or closing the switch at such moments, the voltage stored on the second capacitance is substantially zero. This allows to change state of the switch (i.e. open when it was closed or vice versa) at every half-cycle (half period) rather than only after even one or more full cycles. This allows faster correction or adjustment of the oscillating circuit. In addition, the zero-crossing moments are substantially independent of the amplitude of the signal, which is useful (inter alia) when transmitting ASK modulated signals.

It is an advantage that the state of the switch S1 (open or closed) is maintained between zero-crossing moments. In this way the voltage waveform generated by the resonant circuit is effectively a concatenation of half cycles at the first or second resonance frequency.

Opening or closing the first switch S1 at said zero-crossing moments allows to adjust the phase of the oscillating voltage at the resolution of half cycles, in contrast to full cycles in some prior art documents. This allows more accurate tuning.

In an embodiment, the driver circuit further comprises a clock generator adapted for generating a clock signal having a frequency of at least 2.0 times the target frequency; and the monitoring means is adapted for detecting said zero-crossing-moment at the resolution of said clock signal.

Preferably the clock is at least 4 times, or at least 8 times, or at least 16 times, or at least 32 times, or at least 64 or at least 128 or at least 256 times or at least 512 times the target frequency. The higher the oversampling rate, the more accurate the moments of zero-crossing can be determined, and the more accurate the timing at which the switch is opened or closed can be determined, which reduces harmonic distortion.

The clock may for example be generated by a discrete crystal module or may be generated based on a crystal oscillator or may even be generated by an RC-oscillator (for example a trimmed RC oscillator), or in any other suitable way.

In particular embodiments, the oversampling frequency may for example be a frequency in the range from 10 MHz to 40 MHz, for example about 32 MHz.

In an embodiment, the target frequency is a frequency in the range from 10 kHz to 500 kHz, preferably in the range from 20 kHz to 250 kHz, preferably in the range from 50 kHz to 200 kHz, for example in the range from 100 kHz to 150 kHz, for example a frequency of about 125 kHz.

This frequency range is very well suited for passive keyless entry systems in vehicles.

In an embodiment, the control circuit is further adapted for determining if the zero-crossing moments occurred sooner or later than a reference moment at which the zero-crossing should occur if the resonant circuit was oscillating at the target frequency, and in case it is determined that the zero-crossing-moment occurred sooner than the reference moment, to provide a control signal for closing the first switch, in case it is determined that the zero-crossing-moment occurred later than the reference moment, to provide a control signal for opening the first switch.

This is one particular embodiment (referred to herein as the "early-late" algorithm) of how the algorithm for opening or closing the first switch can be implemented, such that, on average, the number of oscillations of the resonant antenna circuit per time unit is substantially equal to the target frequency.

In an embodiment, the control circuit further comprises: a digital PLL adapted for receiving zero-crossing events, and adapted for generating a frequency control word; and a sigma-delta modulator adapted for receiving said frequency control word, and for providing said control signal for opening or closing the first switch.

In this embodiment, the sigma-delta modulator ensures that, on average, the number of oscillations of the resonant antenna circuit per time unit is substantially equal to the target frequency.

Preferably the sigma-delta-modulator has an order of at least two, or at least three. It is an advantage of using a sigma-delta-modulator that it provides noise-shaping.

In an embodiment, the monitoring means is further adapted for measuring or extracting amplitude information of the oscillating antenna-voltage; and the driver circuit further comprises an excitation circuit adapted for generating an excitation pulse based on said amplitude information, and adapted for applying said excitation pulse;

The excitation source may comprise a current source or current limiter, adapted for generating or allowing an energizing signal in the form of a single current pulse, having an adjustable or selectable magnitude chosen dependent on the measured amplitude of the oscillating voltage signal.

The monitoring means may be adapted for monitoring, e.g. measuring an amplitude of the oscillating antenna voltage signal.

The current source may be adapted for generating current pulses having a larger energy content (for example pulses having a larger amplitude or a longer duration or both) during start-up of the resonant antenna circuit.

It is an advantage of a driver circuit according to the present invention that the energy efficiency is much improved as compared to systems where a frequency is imposed upon the resonant circuit, due to a frequency mismatch between the imposed frequency and the resonant frequency of the oscillator circuit. A small frequency mismatch can lead to large energy losses. By not imposing a frequency to the resonant circuit, a factor of at least 4.0 or even higher, depending the mismatch between the imposed frequency and the resonance frequency and on the value of Q, can be gained in energy efficiency, compared to circuit which do impose a frequency, but inject energy at moments in time synchronous with the oscillating voltage itself.

In a preferred embodiment, the oscillating signal is sampled and optionally digitized at the moment of occurrence of a local minimum and/or a local maximum.

It is an advantage of measuring the amplitude of the oscillating voltage because it allows to accurately adjust the excitation signal (e.g. its amplitude or its frequency) so that an appropriate, e.g. the most appropriate amount of energy is provided to the resonant circuit.

In an embodiment, the excitation circuit is adapted for applying said excitation pulse at a moment in time corresponding to the zero-crossing-moment plus a delay, wherein the delay is substantially equal to ΔT+(PW/2), where ΔT is substantially equal to 1/(4 x ftarget), and PW is a pulse with of the excitation pulse, or wherein the delay is substantially equal to (ΔT1)+(PW/2), where ΔT1 is substantially equal to 1/(4 x fres1), and PW is a pulse with of the excitation pulse, or wherein the delay is substantially equal to (ΔT2)+(PW/2), where ΔT2 is substantially equal to 1/(4 x fres2), and PW is a pulse with of the excitation pulse.

The delay may be a predefined fixed delay, for example corresponding to one quarter (1/4th) of the period corresponding to the first (or second or average of the first and second) resonance frequency minus a predefined value corresponding to half the width of the current pulse. In this way, the top of the excitation pulse will substantially coincide with a moment in time at which the oscillating antenna voltage will reach a local minimum or a local maximum amplitude. (a local maximum in absolute value), and at which the current flowing through the antenna is close to zero.

It is an advantage of inserting current pulses at moments at which the voltage amplitude is maximal and the current is minimal because at these moments the energy injected in the resonant circuit is maximal.

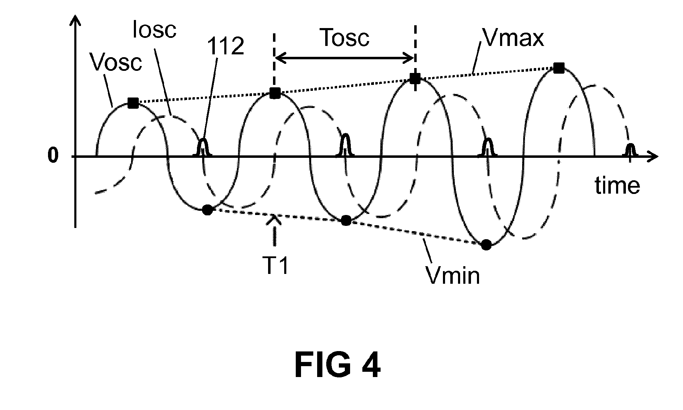

It is noted that the current pulses may be injected only at zero-crossings where the slope of the oscillating antenna voltage is decreasing (as shown for example in FIG. 4). Alternatively it would also be possible to inject current pulses only at zero-crossing-moments where the slope of the oscillating antenna voltage is increasing, although in this case the direction of the current should be adjusted. Of course, it would also be possible to inject current pulses at both moments, but given the high-Qfactor, that is not required, and a simpler solution is preferred.

In an embodiment, the excitation circuit comprises a digitally controllable current source or a digitally controllable current limiter.

It is an advantage of using a current pulse having an adjustable or selectable magnitude because it allows to inject more or less power depending on how much power is required to sustain the oscillation, for example to inject an optimal amount of power.

In an embodiment, the driver circuit further comprises a damping circuit adapted for actively damping the oscillating voltage signal.

It is an advantage of using a damping circuit (rather than letting the energy of the resonant circuit decrease by itself), because this allows to stop the oscillations much more quickly, for example within 3 cycles of the target frequency. This is especially advantageous for resonance circuits with high quality factor antennas (e.g. Q larger than 15), and when transmitting a modulated waveform.

In embodiments of the present invention, the driver circuit may further comprise at least one DC-DC converter adapted for providing a voltage of at least 40 V.

It is an advantage of providing a relatively large voltage, for example in the order of tenths of Volts, e.g. at least 40 V, or at least 60V or at least 80V, because it allows driving the antenna with higher amplitudes and therefore reaching higher magnetic field strengths and communication over longer distances.

In an embodiment, the driver circuit further comprises an input port adapted for receiving a binary input signal; and the control circuit is further adapted for starting and stopping the oscillating waveform based on said binary input signal, thereby transmitting a modulated signal.

It is an advantage of this driver circuit that it can drive the resonant antenna circuit so as to provide an OOK (On-Off-Keying)-modulated transmission signal, e.g. by starting oscillation at a rising edge of the binary bitstream, maintaining oscillation while the bitstream is high (e.g. '1'), actively damping the oscillation at a falling edge of the binary bitstream, and not controlling or actively damping the resonant circuit while the bitstream is low (e.g. '0').

But the driver circuit can also be used for modulating the carrier with amplitude shift keying (ASK) or phase shift keying (PSK).

In an embodiment, the driver circuit is connectable to said resonant antenna circuit, and said resonant antenna circuit furthermore comprises a second switch in series with the inductor coil in its first branch; and the driver circuit further comprises an input port adapted for receiving a binary input signal; and the control circuit is furthermore adapted for selectively opening and closing said second switch only when transmitting a modulated signal, for example only due to transitions of the binary input signal, and for keeping the second switch closed otherwise.

The driver circuit may be integrated in a semiconductor device, in particular a CMOS device.

In a second aspect, the present invention provides a transmitter circuit for transmitting an electromagnetic signal in a predefined frequency range comprising a predefined target frequency, the transmitter circuit comprising: a resonant antenna circuit and a driver circuit as described in the first aspect, operatively connected to said resonant antenna circuit.

In an embodiment, the value of the inductance of the antenna and the value of the first capacitance is chosen such that the first resonance frequency (when the first switch is open) is a value in the range from 70% to 99% (e.g. in the range from 70% to 95% or 70% to 90% or 80% to 90%) of the target frequency, and the value of the inductance of the antenna and the value of the first capacitance and the value of the second capacitor is chosen such that the second resonance frequency (when the first switch is closed) is a value in the range from 101% to 130% (e.g. in the range from 105% to 130% or 110% to 130% or 110% to 120%) of the target frequency

In an embodiment, a ratio of the capacitance of the second capacitor (C2) and the capacitance of the first capacitor (C1) is a value if the range from 0.10 to 0.30, preferably a value in the range from 0.12 to 0.24, more preferably in the range from 0.18 to 0.22.

In an embodiment, the resonant antenna circuit is an assembly containing only one inductor coil, only two capacitors, namely the first capacitor (C1) and the second capacitor (C2), and only one switch (S1) in series with the second capacitor (C2).

Suitable external capacitors rated for the envisioned relatively high voltage and high current are quite expensive. Therefore requiring only two such capacitors reduces costs.

A resonant antenna circuit of this kind is shown in FIG. 3. In these embodiments, the first branch only contains a single component: the inductor coil, and the second branch only contains a single component: the first capacitance (preferably in the form of a single physical capacitor), and the third branch only contains two component: a second capacitance (preferably in the form of a single physical capacitor) and a switch, e.g. a semiconductor transistor in series with the second capacitor.

It is an advantage of using such a resonant antenna circuit that it contains only few components (component cost) and does not contain additional components which would cause an increase power dissipation.

It is an advantage that no switch is required between the driver circuit and the resonant circuit (or as part of the driver circuit but in series with the interface node), because such a switch always has an "RDSon" which inevitably leads to losses, and to a lower quality factor, and to a variation or deviation of the resonance frequency. In other words, the circuit of the present invention has the advantage that the quality factor of the oscillation frequency is increased, and resistive losses can be decreases.

In an embodiment, the driver circuit is adapted for simultaneously driving at least two or at least three resonant antenna circuits, using a single clock signal, for example a 32 MHz clock signal.

In a third aspect, the present invention provides a method of driving a resonant antenna circuit for generating an oscillating voltage signal at a predefined target frequency, the resonant antenna circuit comprising three branches connected in parallel, including: a first branch comprising an inductor coil; a second branch comprising a first capacitance; a third branch comprising a second capacitance connected in series with a first switch; and wherein the first capacitance is chosen such that the antenna circuit has a first resonance frequency higher than the target frequency if the first switch would be permanently open; wherein the second capacitance is chosen such that the antenna circuit has a second resonance frequency lower than the target frequency if the first switch would be permanently closed; the method comprises the steps of: a) monitoring the oscillating voltage signal of the resonant antenna circuit; b) detecting oscillations of said oscillating voltage signal; c) dynamically controlling the first switch in such a way that, on average, the number of oscillations of the oscillating voltage per time unit is substantially equal to the target frequency.

In an embodiment, detecting oscillations of said oscillating voltage comprises measuring or determining or extracting amplitude and/or phase information from said oscillating voltage.

In an embodiment, step b) comprises detecting zero-crossing-moments defined as moments in time at which the oscillating voltage crosses a predefined DC level; and wherein step c) comprising optionally or conditionally opening and closing the first switch at said zero-crossing moments (for example only at said zero crossing moments), and for keeping the first switch open or closed between said zero-crossing moments.

In a fourth aspect, the present invention provides a method of transmitting an electromagnetic signal in a predefined frequency range comprising a predefined target frequency, the method comprising: a method of driving a resonant antenna circuit according to the third aspect; and a method of energizing said resonant antenna circuit, comprising the steps of: d) extracting amplitude information from the oscillating voltage; e) generating excitation pulses for maintaining the oscillating voltage; f) applying said excitation pulses at a delay after said "zero-crossing-moment", wherein the delay is substantially equal to $\Delta T+(PW/2)$, where $\Delta T$ is substantially equal to $1/(4 \times f_{target})$, and PW is a pulse with of the excitation pulse, or wherein the delay is substantially equal to $(\Delta T1)+(PW/2)$, where $\Delta T1$ is substantially equal to $1/(4 \times f_{res1})$, and PW is a pulse with of the excitation pulse, or wherein the delay is substantially equal to $(\Delta T2)+(PW/2)$, where $\Delta T2$ is substantially equal to $1/(4 \times f_{res2})$, and PW is a pulse with of the excitation pulse.

It is an advantage of a driver circuit according to the present invention that it allows to provide energy to the resonant circuit to compensate for energy losses. These losses need not be measured beforehand (e.g. during calibration), but are measured during operation, and by adjusting the excitation signal correspondingly, it is possible to provide the right amount of energy on the fly, in a manner which is robust to variations over time (temperature, aging, etc).

The excitation signal may be configured for starting oscillation of the resonance antenna circuit, or for maintaining oscillation of the resonance antenna circuit with substantially constant amplitude, or for stopping the oscillation.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

**Brief description of the drawings**

**FIG. 1** shows a traditional PKE driver system that uses an antenna in series resonance mode and drives the antenna with a voltage signal.

**FIG. 2** shows a high level block diagram of a transmitter device according to an embodiment of the present invention. The transmitter device comprises a driver circuit and a resonant antenna circuit.

**FIG. 3** shows a block-diagram of a resonant circuit according to a preferred embodiment of the present invention, comprising or consisting of three parallel branches, including a first branch containing an inductor coil, and a second branch containing a first capacitor, and a third branch containing a second capacitor in series with a first switch.

**FIG. 4** shows an example of an oscillating voltage waveform as can be generated by the resonant circuit of FIG. 2, and excitation pulses as can be applied by the driver circuit of FIG. 2.

**FIG. 5(a)** shows a variant of the resonant antenna circuit of FIG. 3, furthermore comprising a freeze switch SF arranged in series with the inductor coil as part of the first branch, as another embodiment of a resonant antenna circuit according of the present invention. The freeze switch is intended to be opened and closed only during data-transmission (e.g. as a result of or in response to changes in a binary bit-stream to be transmitted), and to remain closed otherwise.

**FIG. 5(b)** shows a variant of the resonant antenna circuit of FIG. 5(a), where the switch SF is arranged in series with the first capacitor as part of the second branch, as another embodiment of a resonant antenna circuit according of the present invention. The freeze switch is intended to be opened and closed only during data-transmission (e.g. as a result of or in response to changes in a binary bitstream to be transmitted), and to remain closed otherwise.

**FIG. 6** shows another variant of the resonant antenna circuit of FIG. 3, furthermore comprising a fourth parallel branch, comprising a third capacitor in series with a second switch, as another embodiment of a resonant antenna circuit according to the present invention.

**FIG. 7** shows a more detailed block diagram of a driver circuit and a transmitter device according to an embodiment of the present invention. The driver circuit of FIG. 7 is configured for performing a relatively simple tuning algorithm, referred to herein as the "early-late" algorithm, further illustrated in FIG. 9.

**FIG. 8** shows an example of an excitation pulse as can be used in embodiments of the present invention.

**FIG. 9** shows exemplary waveforms as can be generated by and/or applied to the resonant antenna circuit using embodiments of the present invention, for example the driver circuit of FIG. 7.

**FIG. 10** shows a method of driving a resonant antenna circuit, according an embodiment of the present invention. These method steps illustrate mainly the aspect of frequency tuning in an energy efficient manner.

**FIG. 11** shows a method of energizing a resonant antenna circuit, according to an embodiment of the present invention. These method steps illustrates mainly the aspect of energizing the resonant circuit in an energy efficient manner.

**FIG. 12** shows a variant of the high level block diagram of FIG. 2, as another embodiment of a transmission device and driver circuit according to the present invention. In addition to the blocks shown in FIG. 2, the driver circuit of FIG. 12 additionally has a bitstream-input and a damping circuit, and is adapted for transmitting a modulated signal.

**FIG. 13** shows an exemplary waveform of a binary bitstream as may be applied to the transmission device of FIG. 12, and a corresponding OOK modulated signal as can be generated by the transmission device of FIG. 12.

**FIG. 14** shows exemplary waveforms to illustrate a fast start of the resonant circuit using special energizing pulses.

**FIG. 15** shows exemplary waveforms to illustrate a fast stop of the resonant circuit using active damping pulses.

**FIG. 16(a)** shows a block-diagram of a driver circuit according to an embodiment of the present invention, using the resonant antenna circuit of FIG. 5(a), adapted for temporarily freezing the oscillation only during data transmission.

**FIG. 16(b)** shows a block-diagram of a driver circuit according to an embodiment of the present invention, using the resonant antenna circuit of FIG. 5(b), adapted for temporarily freezing the oscillation only during data transmission.

**FIG. 17** shows an example of an energizing pulse as can be used in embodiments of the present invention.

**FIG. 18** shows the frequency spectrum that would be obtained if the energizing pulse of FIG. 17 is repeated exactly at 125 kHz. As can be seen, the difference between the top of the main lobe and the top of the second harmonic is about 40 dB.

**FIG. 19** shows an example of a frequency spectrum of the oscillating voltage obtainable with the transmission device and driver circuit of FIG. 7, using the "early-late" algorithm, for a continuous waveform, with Lantenna=52$\mu$H, Rantenna=1$\Omega$, Q=40, C1=28nF, C2=6nF, clk=32MHz. As can be seen, the difference between the top of the main lobe and the top of the second harmonics is about 30 dB.

**FIG. 20** shows a single plot with several frequency spectra similar to FIG. 19, using the same parameters as in FIG. 19, for different values of C1 in the range from 26 nF to 30 nF. As can be seen, the main lobe has the same characteristics as in FIG. 19.

**FIG. 21** shows a single plot with several frequency spectra similar to FIG. 19, using the same parameters as in FIG. 19, for different values of C2 in the range from 4 nF to 8 nF. As can be seen, the main lobe has the same characteristics as in FIG. 19.

**FIG. 22** shows a single plot with several frequency spectra similar to FIG. 19, using the same parameters as in FIG. 19, for different values of Lantenna in the range from 48 $\mu$H to 57 $\mu$H. As can be seen, the main lobe has the same characteristics as in FIG. 19.

**FIG. 23** shows another block-diagram of a transmission device according to the present invention, having a first pulse generator arranged between the antenna circuit and ground, for use during start-up and during continuous oscillation, and a second pulse generator arranged in parallel with the antenna circuit for use during active damping.

**FIG. 24** illustrates an advantage of using two pulse generators as shown in FIG. 23.

**FIG. 25** shows another detailed block diagram of a driver circuit and a transmitter device according to an embodiment of the present invention. This driver circuit can be seen as a variant of the driver circuit of FIG. 7. The driver circuit of FIG. 25 is configured for performing a somewhat more complex tuning algorithm than the "early-late algorithm", based on "sigma-delta modulation".

**FIG. 26** is a qualitative graph illustrating an effect of using a second or third order sigma-delta modulator (as shown in FIG. 25) as compared to the simply early-late algorithm of FIG. 7.

**Detailed description of illustrative embodiments**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

In this document, the terms "bitstream" and "datastream" as used a synonyms.

In this document, the term "excitation pulses" and "energizing pulses" are used a synonyms. In preferred embodiments of the present invention, the pulses are provided in the form of "current pulses". Depending on the timing and the direction of the current pulses, these pulses can be used either to increase the amplitude of the oscillating voltage (e.g. for starting or maintaining oscillation), or to decrease the amplitude of the oscillating voltage (e.g. for damping or stopping the oscillation).

In this document, the terms "transmit frequency", "carrier frequency" and "target frequency" are used as synonyms.

In the present invention, the terms "inductor coil" and "antenna" are used as synonyms, to represent the coil of an antenna, for example the coil of a magnet antenna or ferrite antenna. In the drawings this coil will be represented by a rectangle containing a "pure inductance" (Lantenna) and a "pure resistance" (Rantenna) although in practice these elements cannot be separated.

In this document, "LF frequency" means "Low Frequency" which is a frequency in the range from 50 kHz to 500 kHz, for example in the range from 100 kHz to 250 kHz. The present invention can be used inter alia in the field of Passive Transponders or RFID tags (range: 100 to 150 kHz), or for wireless power charging, for example according to the WPC-standard (105 to 205 kHz) or according to the PMA-standard (from 235 to 275kHz).

Where in the present invention the word "capacitance" is used, what is meant is a "fixed capacitor". This capacitor can be in the form of a single capacitor device or can consist of more than one physical capacitor connected in series and/or in parallel (as is well known in the art). With "fixed capacitor" is meant that its capacitance value cannot be varied mechanically or electrically for example, in contrast for example to a "variable capacitor".

In this document, the terms "master clock" or "reference clock" or "oversampling clock" are used as synonyms.

In this document, the terms "damping pulses" or "current pulses to stop the oscillation" mean the same.

In this document, an "average over time" or "an average per time unit" means the same.

The present invention relates to wireless transmission devices (in general), and in particular to a driver Low-Frequency (LF) mechanism as can be used for example in Passive Entry (namely PEPS or PKE) applications or Passive Start Entry (PSE) applications, where a driver circuit is adapted for providing a high power drive signal (e.g. up to 4App and 100Vpp) to a resonant circuit such as, but not limited to a magnetic LC resonant circuit.

**FIG. 1** shows a traditional PKE driver system that uses an antenna in series resonance mode, as already described above, in the background section. The antenna is represented by a pure inductance "Lantenna" in series with a pure resistance "Rantenna". The latter is not a discrete resistor, but represents the internal electrical resistance of the antenna coil itself. This representation will be used throughout this document. A typical value for Rantenna is a value in the range from 0.5 to 1.5 Ohm, for example about 1.0 Ohm for an antenna having an inductance in the order of about 50 μH. The circuit of FIG. 1 also contains a discrete series resistor "Rseries" having a resistance in the order of about 5 to 15 Ohms, for example about 10 Ohm, which is used to deliberately lower the Q-factor of the resonant circuit.

The presence of this series resistor "Rseries" has both a positive and a negative aspect. A negative aspect is that the series resistor consumes power, a positive effect is that it broadens the bandwidth of the resonance circuit, which in turn reduces amplitude differences when energizing the resonant circuit by by driving the resonance circuit at an excitation frequency slightly different from the resonance frequency of the resonance circuit.

It is a challenge to find a circuit and/or method that simultaneously offers both high-energy efficiency (or low losses), and at the same time the ability to transmit at a predefined frequency or in a relatively small band containing said predefined frequency. The predefined frequency is called "carrier frequency".

The classical approach to achieve high-energy efficiency is to use a resonance circuit having a high Q-factor, but this causes a very narrow bandwidth around the carrier frequency, the location of which carrier frequency is highly dependent on the components values of the physical inductor coil and the physical capacitor being used. The resonance frequency of a resonant circuits with a high Q-factor cannot easily be tuned or shifted by injecting an energizing waveform or energizing pulses at a slightly different frequency than the resonance frequency, without decreasing the overall energy efficiency. Hence, these are conflicting requirements.

It is even more a challenge to find such a circuit and method in which the carrier frequency is moreover substantially independent of the component values of the resonance circuit.

This is relevant for the envisioned applications, for example because the value of the inductance "Lantenna" may change due to potential metallic surrounding, component tolerances, and parasitics of the wiring harness. Specifically, metallic surrounding decreases the inductance of the antenna, which causes an increase of the resonance frequency. The decrease of the inductance can be down to 70% of the initial value, if the antenna in open space is compared to the same antenna mounted on a metal plate. This causes an increase of the resonant frequency of 20% in this very extreme case. This may cause problems with the frequency tolerance of transponders/tags to be used together with the driver.

Such "frequency shift" not only causes problems for reception by a single receiver, but also causes problems when simultaneously transmitting on multiple antennas, for example when simultaneously transmitting on at least 2 or on at least 3 different antennas, which may lead to signal fading or even signal cancelation.

In order to address at least some of these problems, the present invention provides a transmitter device 200 (e.g. see FIG. 2) comprising a driver circuit 210 connected to a particular kind of resonant antenna circuit 201. Four examples of suitable antenna circuits 301, 501, 601 are shown in FIG. 3, FIG. 5(a), FIG. 5(b) and FIG. 6, but the present invention in not limited to these specific examples.

**FIG. 3** shows a preferred embodiment of a resonant antenna circuit 301 as can be used in the transmitter device of FIG. 2. The resonant antenna circuit comprises three parallel branches: a first branch containing an inductor coil 331, for example a magnet antenna or a ferrite antenna; a second branch containing a first capacitor C1 connected in parallel with the inductor coil 331; a third branch containing a second capacitor C2 connected in series with a first switch S1, the series connection of the second capacitance C2 and the first switch S1 being connected in parallel with the inductor coil 331.

Suppose for example that the resonance antenna circuit is to transmit at a target frequency of 125 kHz, And that it comprises an inductor coil 331 with an inductance of 52 μH and an internal resistance of about 1Ohm.

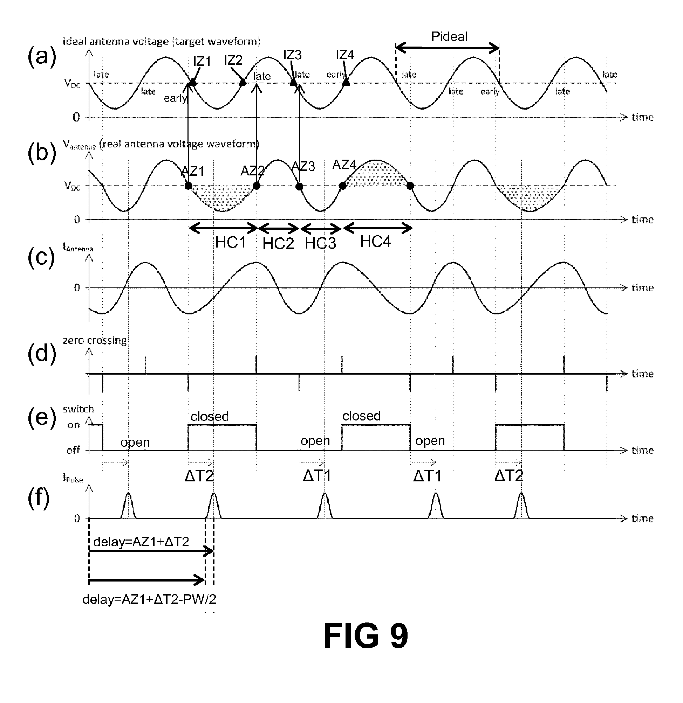

The first capacitance C1 is then chosen such that the antenna circuit 301 has a first resonance frequency "fres1" higher than a predefined carrier frequency (e.g. 5% to 30% higher) if the first switch S1 would be permanently open, and the second capacitance C2 is chosen such that the antenna circuit 301 has a second resonance frequency fres2 lower than the predefined carrier frequency (e.g. 5% to 30% lower) if the first switch S1 would be permanently closed. As will be described further (see for example FIG. 9), it is not the intention to keep the first switch S1 permanently open or permanently closed, but to control the first switch S1 in a particular manner.

Preferably the antenna circuit has a Q-factor of at least 10, or at least 15, or at least 20, or at least 25 or at least 30 or at least 35 (when measured with the switch S1 permanently open)

In the embodiment of FIG. 3, the first capacitance C1 is directly connected in parallel with the inductance, meaning that the ends of the inductor coil 331 are connected to corresponding ends of the first capacitor C1 without any intermediate components such as a diode or a switch or a discrete resistor or any other component.

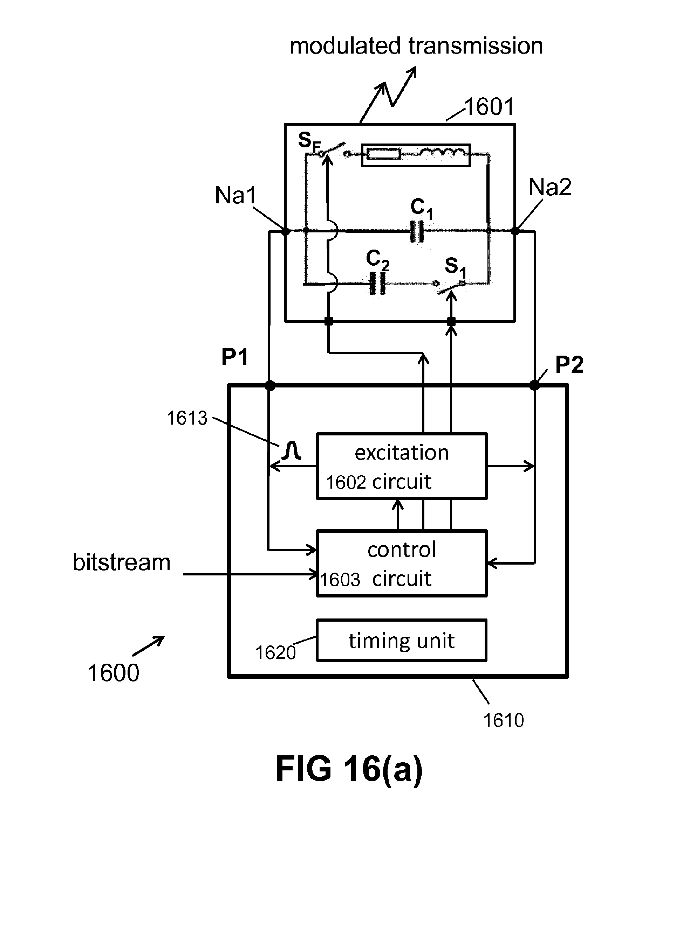

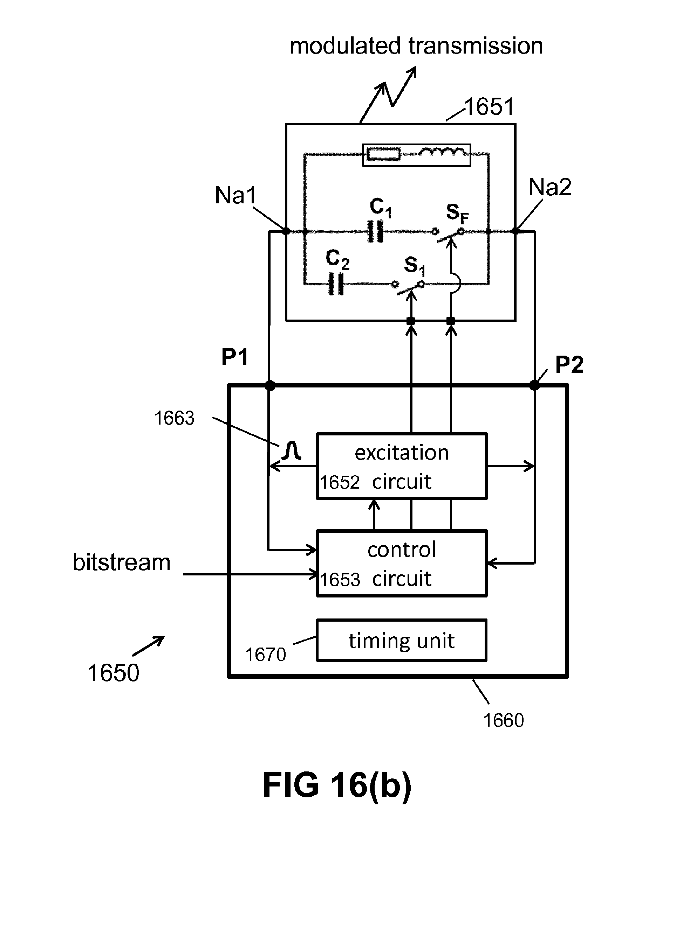

In other embodiments, the inductor coil 531 and the first capacitor C1 are directly connected at first ends, but indirectly via a switch SF at their other ends, as shown for example in FIG. 4, for reasons that will be explained further (see FIG. 16). For now it suffices to know that this switch SF is purely optional, and if present, is intended to be opened only during data communication, to temporarily freeze the resonant circuit without having to discharge.

Preferably the antenna circuit 201, 301, 501, 601 does not have any discrete resistors, although the resonant circuit and the transmitter device would still work. Such discrete resistor(s) would have a negative influence on the energy efficiency.

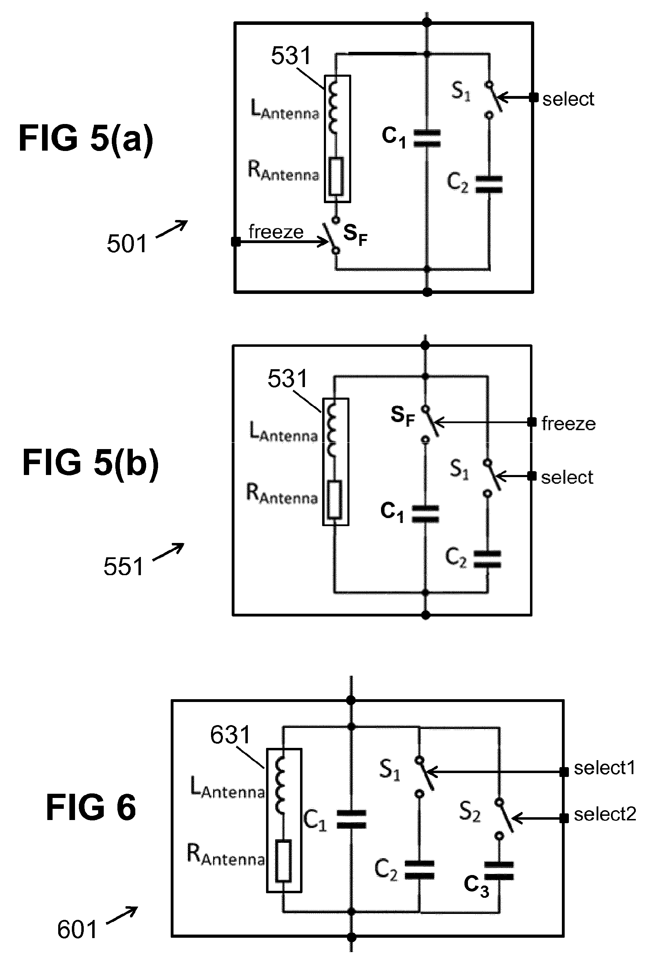

The antenna circuits of FIG. 3 and FIG. 5(a) and FIG. 5(b) have only three parallel branches, but the present invention is not limited thereto, and the resonant antenna circuit may comprise more than three parallel branches, as shown for example in **FIG. 6.** As can be seen, the antenna circuit 601 has a fourth parallel branch containing a second switch S2 and a third capacitor C3 connected in series. The value of the capacitance C3 is preferably chosen to be about 50% of C2.

In a variant of the resonant circuit of FIG. 6 (not shown), the first branch would also comprise a switch SF in series with the inductor coil 631, in a manner similar to FIG. 5(a) or FIG. 5(b).

The skilled person, having the benefit of the present disclosure can easily come up with other embodiments using the same principles as described herein.

An advantage of the antenna circuit 301 of FIG. 3 is that it does not have a switch SF in series with the inductor coil 331, and does not have a discrete resistor in series with the inductor coil (as in some prior art devices), thereby avoiding energy losses because such switch and/or resistor would have to conduct the entire oscillating current that flows through the antenna coil, which can easily amount to about 10 Amp peak-to-peak for the envisioned applications.

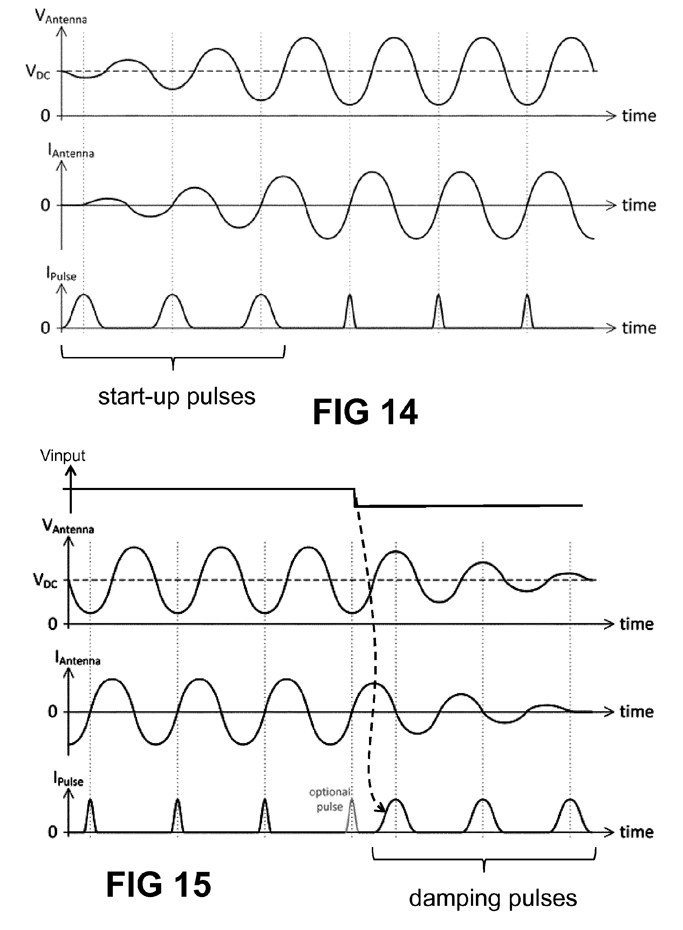

Another advantage of the antenna circuit of FIG. 3 is that the oscillation circuit is never opened (in contrast to some prior art solutions), resulting in a continuous oscillation without "dead moments" at which the voltage is kept constant. Or in other words, by not interrupting the oscillations, abrupt variations in the current waveform and/or the voltage waveform can be avoided (see for example FIG 9(b) and FIG. 9(c)). In this way higher harmonics can be reduced, which is beneficial for compliance with EMC regulations. If no transmission is desired, the resonant antenna circuit can be stopped, as will be described further (see FIG. 15).

In all embodiments of the present invention, the first switch S1 allows to selectively connect the second capacitance C2 in parallel with the first capacitance C1 at appropriate moments to slightly adjust the frequency of the oscillating voltage Vosc, and thus (over time) influence the carrier phase, but in a manner which is highly energy efficient by allowing the resonant circuit to resonate at one of its resonance frequencies. It is noted that the switch S1, when closed, evidently creates some energy loss, but this amount is limited because of two reasons:

(i) because the third branch are containing the second capacitor C2 and the switch S1 does not conduct the full antenna current, but part of the antenna current flows through the second branch containing C1, and

(ii) because the switch S1 is only closed during some, but certainly not all cycles or half cycles, as will become clear when discussing FIG. 9.

These are the main underlying principles of the present invention, which simultaneously solve the problem of high-energy efficiency and the problem of transmitting at a predefined carrier frequency.

The solution provided by the present invention is believed to be counter-intuitive inter alia because it would be logical to expect that the frequency spectrum of a resonant antenna circuit having a high-Q value (for example in the order of 30 or more) would result in a sharp peak (like a pure sine wave), but since there are two discrete and distinct resonance frequencies, one would expect two such peaks, one for each resonance frequency. However, as will be shown further, that is not the case.

Referring back to **FIG. 2,** the resonant antenna circuit 201 has two nodes Na1 and Na2 over which it provides an oscillating voltage Vosc (after being excited). The driver circuit 210 of FIG. 2 has two interface nodes or pins P1 and P2 respectively connected to the nodes Na1 and Na2 of the antenna circuit 201. The driver circuit 210 contains a control circuit 203 adapted for monitoring the oscillating voltage signal Vosc provided by the resonant antenna circuit 201, and for extracting timing information and amplitude information of said oscillating voltage signal Vosc. The control circuit 203 then provides timing information and amplitude information to an excitation circuit 202. The excitation circuit 202 is adapted for generating an excitation signal 213 based on said timing information and amplitude information, and is adapted for applying said excitation signal to the interface nodes or pins P1, P2 and thus to the resonant antenna circuit 201.

**FIG. 2** shows a high-level block diagram. Particular embodiments of the driver circuit may of course comprise additional blocks, such as for example: active damping control, an internal clock generator, a data modulator, an internal DC/DC convertor, a second energizing circuit, etc.

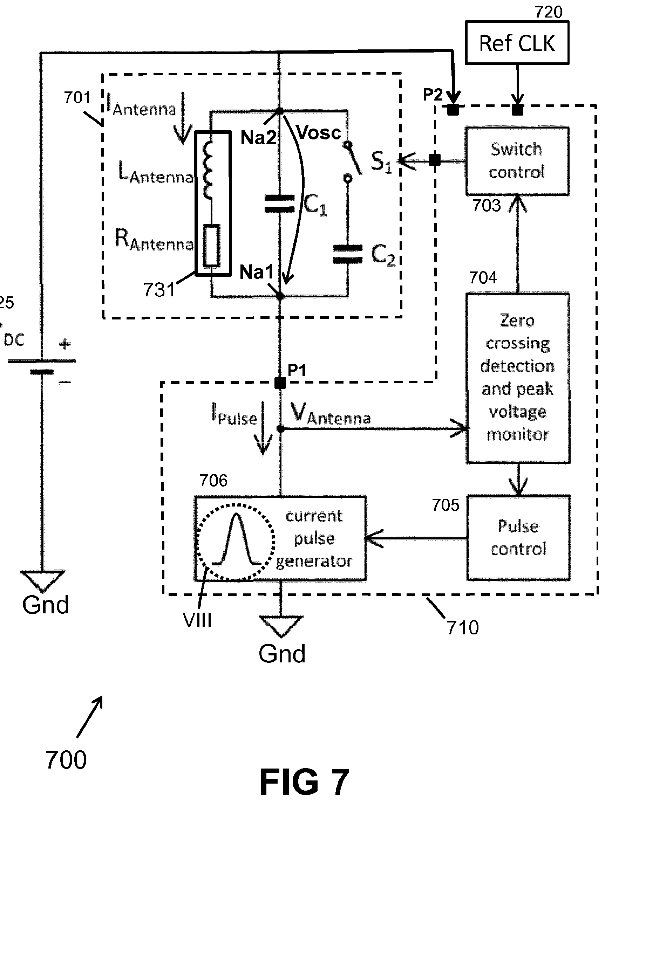

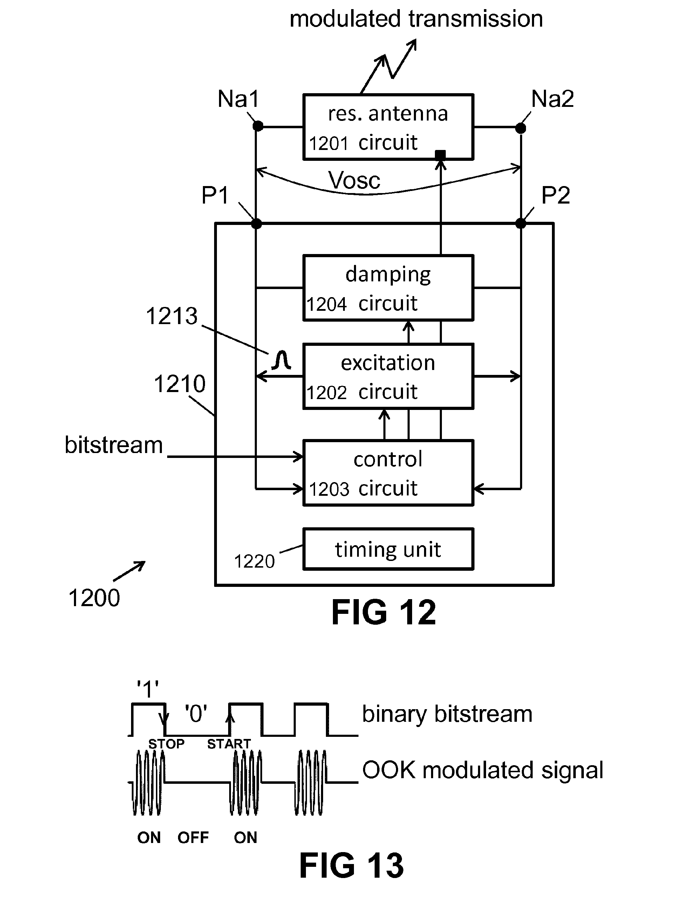

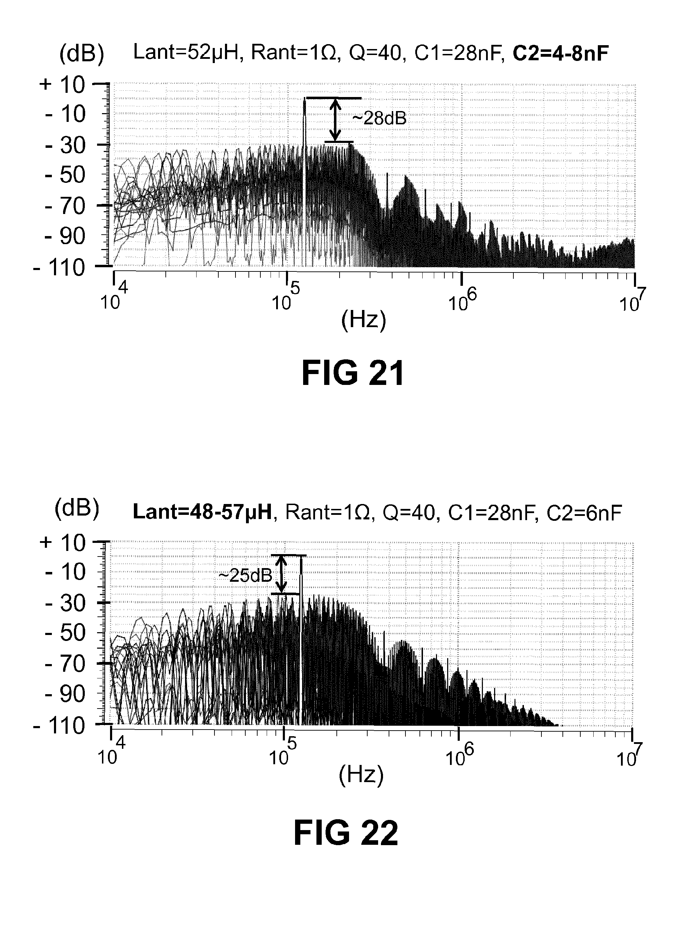

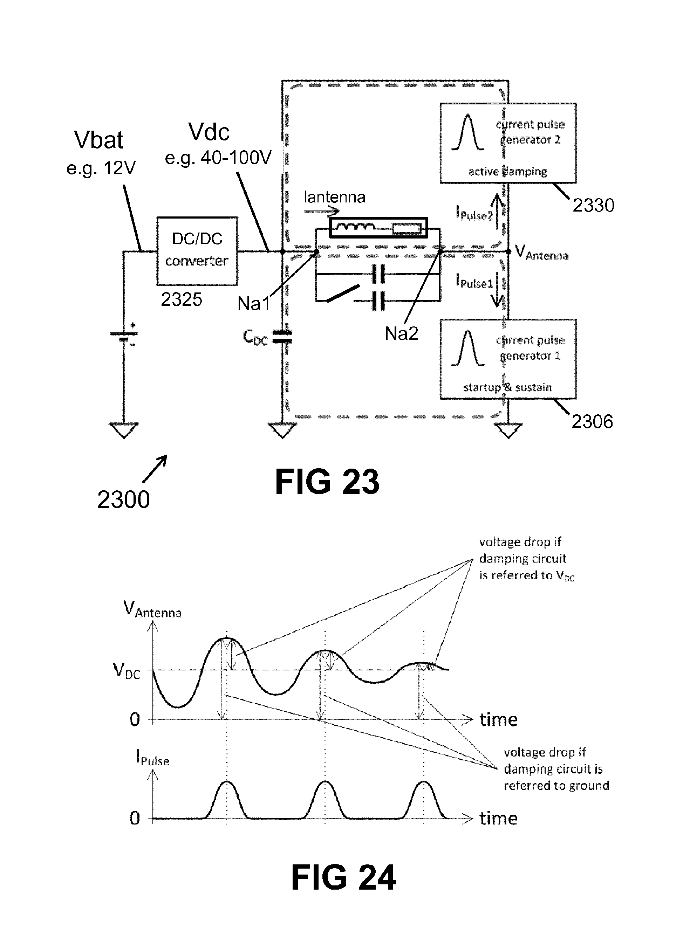

Other embodiments will be shown in FIG. 7, FIG. 12, FIG. 22 and FIG. 24, but each of these block-diagrams is mainly focused on one particular function, e.g. FIG. 7 is primarily intended to describe the "early-late" algorithm, FIG. 12 is primarily intended to describe damping and data-communication, FIG. 22 is primarily intended to describe two separate current generators, and FIG. 24 is primarily intended to describe a sigma-delta modulator. In order to keep the number of drawings reasonable, it is explicitly pointed out that different functions can be combined, without actually showing them in combination.

During normal operation, there are actually two control mechanisms operating:

(a) a first control mechanism that controls the amplitude of the oscillation voltage Vosc by injecting suitable current pulses at appropriate moments in time (see FIG. 4),
(b) a second control mechanism that controls the phase (and thus also the carrier frequency) of the oscillation voltage Vosc, by selectively opening and closing the first switch S1 at appropriate moments in time, and based on a predefined criterium according to which the first switch S1 is to be opened or closed, such that, on average, the number of oscillations of the resonant antenna circuit 201 per time unit is substantially equal to the predefined target frequency.

FIG. 4 illustrates the main principles of the first control mechanism that controls the amplitude of the oscillating voltage Vosc. FIG. 4 shows an exemplary waveform (black line) of the oscillating voltage Vosc over the inductor coil, and the current Iosc flowing through the inductor coil (dashed line). The current waveform is only shown for illustrative purposes, as it is not measured by the driver circuit 210 according to the present invention.
The control circuit 203 of the driver circuit 210 determines time instances at which the oscillating voltage signal Vosc reaches a local minimum, as indicated by black dots. In FIG. 4 the black dots are interconnected via a dotted line "Vmin" for illustrative purposes. By comparing the amplitudes of these local minimum voltages, for example to the average level Vdc, the control circuit 203 can detect that the voltage swing of the oscillating voltage Vosc is increasing or decreasing over time, and can send information to the excitation circuit accordingly, e.g. for keeping the amplitude substantially constant, or for increasing or decreasing the amplitude, by sending appropriate current pulses with a normal amount of energy, a larger amount or a smaller amount of energy. The normal amount of energy can for example be a predefined amount, e.g. determined during design or during calibration, or may be obtained in a learning mode, can be based on previous energy pulses and previous amplitude measurements.
Instead of, or in combination with the detection of local minima, the driver circuit 110 may also be adapted for detecting local maxima of the oscillating voltage signal Vosc, as indicated by black squares in the waveform of FIG. 4. The local maxima are connected via a dotted line "Vmax" for illustrative purposes.
As can be appreciated from FIG. 4, any of the amplitude of the local minima (relative to the average value Vdc of the oscillating voltage Vosc) or the amplitude of the local maxima (relative to the average value Vdc of the oscillating voltage Vosc) or a difference between a local maximum and a local minimum (Vmax-Vmin), can be used to determine the voltage swing of the oscillating voltage Vosc.

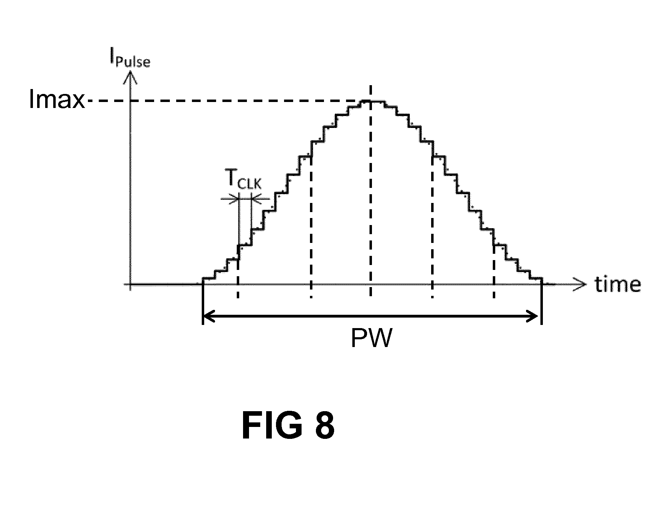

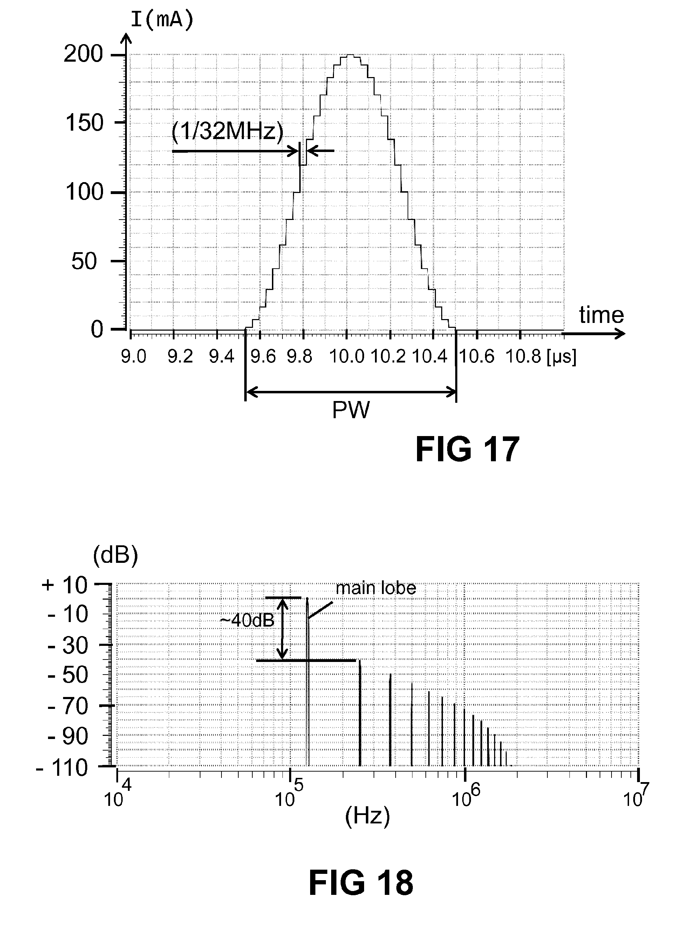

When "starting" the resonant circuit, (see also FIG. 14) excitation pulses are provided to the resonant antenna circuit 201 in order to increase the amplitude or voltage swing of the oscillating voltage Vosc, preferably in as few oscillating cycles as possible, but according to principles of the present invention, always in synchronism with the ongoing oscillations (see also FIG. 9(f)).
When "actively damping" the oscillations of the resonant circuit by means of current pulses (see also FIG. 15 and FIG. 22 and FIG. 23), in contrast to passive damping through a diode or resistor or the like, excitation pulses are provided to the resonant antenna circuit 201 in order to decrease the amplitude or voltage swing of the oscillating voltage Vosc, preferably preferably in as few cycles as possible, but according to principles of the present invention, always in synchronism with the ongoing oscillations (see also FIG. 9(f)).
When "maintaining" the oscillation, excitation pulses are provided to the resonant antenna circuit 201 in order to keep the amplitude or voltage swing of the oscillating voltage Vosc relatively constant, again, always in synchronism with the ongoing oscillations (see also FIG. 9(f)).
In the example of FIG. 4, a single excitation pulse having a suitable size and shape (see also FIG. 8 and FIG. 17) is provided at each moment in time close to the moment at which the oscillating voltage Vosc reaches a local minimum.
Several schemes are possible to determine the time at which the current pulses are to be inject. For instance, a minimum voltage detector based on the derivative of the antenna voltage Vosc could be used, so that the current pulse is inserted at the moment when the antenna voltage reaches a minimum. A disadvantage of this approach is, however, that the maximum of the current pulse would not coincide with the voltage minimum. Another scheme wherein the pulse is applied slightly before reaching the actual minimum voltage will be described in more detail in FIG. 9.
In the example of FIG. 4 energizing pulses are only provided when the oscillating voltage Vosc reaches a local minimum. Alternatively or additionally, energizing pulses having the opposite sign may also be provided when the oscillating voltage Vosc reaches a local maximum (not shown).
Preferably the duration of the energizing pulses is less than 20% of the oscillating period Tosc, or stated more exactly (because there are actually two resonance frequencies), less than 20% of the period corresponding to the highest resonance frequency, preferably less than 15%, for example about 12%. As an example, in case of an oversampling clock of 256 x 125kHz = 32MHz, current pulses having a pulse width of about 20 to 40 clock ticks may be used.
The skilled person can find suitable pulse widths taking into account that:

(i) Larger pulse widths allow more complex pulse shapes and/or allow a better slope control (actually discrete steps), which may be beneficial for EMC (lower harmonics), and may pose lower requirements on the current generator because the current amplitude can be smaller, but may cause somewhat more efficiency loss because the voltage of the antenna will not be zero when the pulse is applied;

(ii) smaller pulse widths require higher current amplitudes for injecting the same amount of energy, provide less steps for defining the pulse shape, but may be more hence pose higher requirements on the current generator, but may cause somewhat less efficiency loss because the pulse can be applied at moments in time when the voltage is closer to zero.

In practical implementations, if the energy content of the pulse to be injected is relatively low, as is the case for example when maintaining a constant amplitude, both the amplitude and the pulse width can be relatively small, and if the energy content of the pulse to be injected is relatively high, as is the case for example during start-up or during active damping, both the pulse width and the amplitude of the pulses can be chosen relatively high.

It is an advantage of embodiments according to the present invention that the exact shape and moment of start and duration of the excitation pulses is not critical for the current application, in the sense that this timing has no significant impact on the carrier frequency itself, but the pulse shape does have an impact on the frequency spectrum outside the frequency range of interest (e.g. near 125 kHz), and the timing does have an impact on the overall energy efficiency of the circuit. In order to reduce the latter impact, an "ideal" moment for starting the pulse will be described in FIG. 9(f).

As mentioned above, **FIG. 5(a), FIG. 5(b) and FIG. 6** show several variants of the resonant antenna circuit of FIG. 3.

The resonant antenna circuit 501 of **FIG. 5(a)** comprises a freeze switch SF arranged in series with the inductor coil as part of the first branch. The freeze switch SF is intended to be opened and closed only during data-transmission, and to remain closed otherwise. Of course the switch SF could also be arranged on the other side of the antenna 531. In order to freeze the oscillation, SF needs to be open.

**FIG. 5(b)** shows a resonant antenna circuit 551 which is a slight variant of the resonant antenna circuit of FIG. 5(a), where the switch SF is arranged in series with the first capacitor as part of the second branch. In order to freeze the oscillation, both switches SF and S1 need to be open. When compared to the circuit of FIG. 5(a), this embodiment has an advantage in efficiency and/or in chip size required for the switches SF, S1, in case the switches are integrated in the driver chip, but that is not absolutely required, and the switches may also be discrete components.

In another embodiment having the same schematic as shown in FIG. 5(b), the antenna circuit could be operated in one of the following modes:

- a first mode wherein switch SF is closed and switch S1 is open. In this mode the oscillating current would flow through the antenna and through C1 but not through C2. The value of C1 would be chosen such that the antenna circuit would have a first resonance frequency lower than a predefined target frequency in this first mode, for example 5% to 30% lower than the target frequency;
- second mode wherein switch SF is open and switch S2 is closed. In this mode the oscillating current would flow through the antenna and through C2 but not through C1. The value of C2 would be chosen such that the antenna circuit would have a second resonance frequency higher than the target frequency in this second mode, for example 5% to 30% higher than the target frequency.

In such embodiment, the ratio of the values C1 and C2 would typically be a value in the range from about 0.5 to about 1.8. When comparing such antenna circuit with that of FIG. 3, the value of the second capacitor C2 would have to be chosen higher (more expensive capacitor), and an additional switch SF would be required, without a real benefit. However, if this antenna circuit would be operated also in a third mode wherein both switches SF and S1 are simultaneously open, the circuit of FIG. 5(b) offers the advantage that the oscillations can be stopped, while the circuit of FIG. 3 cannot. In embodiments of the present invention, the third mode would only be used during data transmission, not for adjusting the phase of the oscillating waveform. See also FIG. 16(b).

**FIG. 6** shows another variant of the resonant antenna circuit of FIG. 3, furthermore comprising a fourth parallel branch, comprising a third capacitor C3 in series with a second switch S2, as another embodiment of a resonant antenna circuit according to the present invention.

Each of the switches SF, S1, S2 etc. shown for example in FIG. 5(a), FIG. 5(b), FIG. 6, FIG. 16(a), FIG. 16(b) etc. can be a semiconductor switch, for example a discrete MOS transistor, or an integrated MOS transistor or a BGT transistor, or "the switch" can be formed by two transistors connected in series or connected in parallel, in manners known per se in the art.

**FIG. 7** shows a block diagram of a driver circuit 710 according to an embodiment of the present invention, connected to the resonant antenna circuit of FIG. 3.

In the example shown in FIG. 7, the clock generator 720 is an external clock generator, and the voltage supply 725 is an external voltage supply, for example an external DC/DC convertor, but of course it would also be possible to integrate the clock generator and/or the DC/DC convertor in the driver circuit.

The driver circuit 710 monitors the oscillating voltage Vantenna, and extracts timing information and amplitude information in block 704. In particular, block 704 determines moments in time at which the antenna voltage Vantenna is equal to the average antenna voltage Vdc (see FIG. 4), which moments in time are referred to herein as "zero-crossings", and also determines the amplitude of the antenna voltage at local maxima or minima thereof (also referred to as "peak voltage").

For completeness, it is noted that Vosc is the voltage over the antenna nodes Na1, Na2, and that Vantenna is the voltage as can be measured between the antenna node Na2 that is not connected to the supply voltage Vdc, and ground Gnd (represented by a triangle), but there is a one-to-one relationship which can be written in mathematical form as follows:

$$Vdc = Vosc(t) + Vantenna(t) \qquad (1),$$

or

$$Vdc = -Vosc(t) + Vantenna(t) \qquad (2),$$

depending on how the polarity of Vosc is chosen. Thus the two waveforms are exactly the same but shifted over Vdc, or are exactly opposite but shifted over Vdc. Indeed, Vosc(t) oscillates around zero Volt (see FIG. 4), while Antenna oscillates around Vdc (see FIG. 9(a)). The "zero crossings" of Vosc coincide with the moments at which Vantenna crosses Vdc, which therefore are also referred herein as "zero crossings", despite that Vantenna(t) actually crosses Vdc.

Since the driver circuit 710 has access to both antenna nodes anyway, it is just a matter of implementation whether Vosc or Vantenna is actually used. In the rest of the description, it will be assumed that Vantenna is used.

This timing information and amplitude information is provided to block 705 "Pulse Control" which is adapted for generating a current pulse having a suitable shape and a suitable width (duration) and a suitable amplitude, for example as amplitude values to be generated by the current pulse generator 706, for example a current DAC or a current limiter. The current generator preferably has a resolution of at least 5 bits (32 values) or at least 6 bits (64 values). The pulse control unit 705 may be adapted for determining an amount of energy to be injected, and for choosing an appropriate pulse width and pulse duration and optionally also pulse shape corresponding to that amount of energy, for example using predefined look-up tables with optional scaling, or in any other way.

**FIG. 8** and **FIG. 17** show examples of current pulses as may be used to energize the resonant antenna circuit in embodiments of the present invention. The particular pulse shown in FIG. 16 has a shape known in the art as "raised cosine", and has a duration of 30 clock ticks at 32 MHz = 937,5 ns and has a peak current "Imax" equal to about 200 mA, but of course this is only an example, and other pulses with another duration and/or another shape (e.g. a triangular pulse or a trapezoidal pulse, or a sinusoidal pulse, etc) and/or another amplitude can also be used. The shaping can be implemented for example with a digitally adjustable current source.

It is an advantage of using a raised cosine shape or another smooth shape rather than a rectangular or triangular shape, because a smooth shape creates lower harmonics in the spectrum, hence allows easier compliance to EMC regulations.

**FIG. 9** shows exemplary waveforms to illustrate how the driver circuit 710 of FIG. 7 works, in particular the timing of the first control mechanism (related to energizing or de-energizing the resonant circuit for starting, maintaining or stopping the oscillation), and the second control mechanism related to selectively opening and closing the first switch S1 for controlling the phase and thus also the frequency (or frequency spectrum) of the oscillation voltage Vantenna.

For ease of description, a specific example will be described, wherein the target frequency is 125 kHz, and the timing unit 720 provides or generates a clock signal of 32 MHz, thus having an oversampling factor of 32 MHz/125 kHz=256, but of course the invention will also work with other frequencies and/or other oversampling factors. It is noted that FIG. 9 is not drawn to scale, but is exaggerated for illustrative purposes, e.g. to clearly show the difference between the two resonance frequencies, although in practice the difference may only be about 10%.

**FIG. 9(a)** shows an ideal, i.e. pure sinusoidal waveform of exactly 125 kHz shifted to Vdc. This waveform is only shown for illustrative purposes, to explain how the algorithm works, but if so desired, may also be stored or generated or calculated in the control circuit, for example as numerical data in a non-volatile memory, in manners known per se in the art.

**FIG. 9(b)** shows an exemplary waveform of the actual antenna voltage "Vantenna(t)" as can be measured between the nodes Na1 and Gnd (see FIG. 7), if the first switch S1 is opened or closed according to the control signal shown in **FIG. 9(e),** where "ON" means that the switch S1 is closed, and "OFF" means that the switch S1 is open.

**FIG. 9(c)** shows the current flowing through the inductor coil "Iantenna", for the sake of explanation, because this current is not actually measured by the driver circuit 710 (in contrast to some prior art solutions).

The proposed "early-late" algorithm for controlling the phase works as follows:

- the control circuit 710 monitors or calculates or determines in any other way at which moments in time IZ1, IZ2, IZ3 of the ideal waveform is equal to or crosses Vdc. ("IZ" stands for "Ideal Zero crossings").
- the control circuit 710 monitors (e.g. measures) the waveform of FIG. 9(b) and determines the moments in time at which the actual oscillating voltage Vantenna is equal to or crosses a predefined voltage level "Vdc". As explained above, these moments are referred to herein as "zero-crossing moments", despite the fact that in reality Vantenna does not cross 0V but Vdc. The voltage level Vdc can be any voltage level, for example a fixed voltage level or a variable voltage level. In the exemplary waveforms shown in FIG. 9(a) and FIG. 9(b) the voltage level is halfway between the minimum voltage level and the maximum voltage level of the oscillating voltage waveform.

Some of these moments are indicated by a black dot and labeled AZ1, AZ2, AZ3 (where "AZ" stands for "Actual Zero crossing").

- the control circuit 710 determines whether the Actual Zero-crossing moment AZi occured before or after the corresponding Ideal Zero Crossing moment IZi,
- and if it is determined that the actual zero crossing is earlier (indicated by "early"), then the first switch S1 will be closed for the next half cycle, i.e. until the next actual zero crossing,
- and if it is determined that the actual zero crossing is later than the ideal zero crossing, then the first switch S1 will be opened for the next half cycle, i.e. until the next actual zero crossing.

Of course the above only explains only the principles of the "early-late" algorithm, and actual implementations need not actually generate the ideal waveform, but can come to the same conclusion based on calculated data, but that is an implementation issue.
The net result is that the actual antenna voltage waveform is actually a concatenation of four possible half cycles:

- a positive half cycle (S1 open) at the first resonance frequency fres1 > fcarrier,
- a negative half cycle (S1 open) at the first resonance frequency fres1 > fcarrier,
- a positive half cycle (S1 closed) at the second resonance frequency fres2 < fcarrier,
- a negative half cycle (S1 closed) at the second resonance frequency fres2 < fcarrier.

The half cycles are concatenated at the actual zero-crossing moments (indicated with black dots), hence a Continuous Waveform is formed, without sudden jumps, which is beneficial for EMC.
Based on the above description, it can now be understood how the control circuit works:

- by monitoring when Vantenna crosses VDC, the zero-crossing moment AZ1 is detected, since AZ1 occurs before IZ (i.e. is "early"), the switch S1 will be closed during the next half cycle HC1,

- the next zero-crossing moment AZ2 is detected when Vantenna crosses VDC, since AZ2 occurs after IZ2 (i.e. is "late"), the switch S1 will be open during the next half cycle HC2,
- the next zero-crossing moment AZ3 is detected when Vantenna crosses VDC, since AZ3 occurs after IZ3 (i.e. is "late"), the switch S1 remains open during the next half cycle HC3,
- the next zero-crossing moment AZ4 is detected when Vantenna crosses VDC, since AZ4 occurs before IZ4 (i.e. is "early"), the switch S1 is closed during the next half cycle HC4,
  etc.

**FIG. 9(f)** also shows a possible timing of when to apply the energizing pulses, which are current pulses. It is preferred (for energy efficiency reasons and EMC reasons) that the pulses are injected at or near the moment at which the antenna current Iantenna is substantially zero. But since the energizing pulses have a non-zero duration or pulse width PW (see for example FIG. 8 and FIG. 16), and the current flowing through the inductor coil is not measured by the control circuit 710, the moment at which the energizing pulses are to be injected need to be determined in another way. One possible way is to calculate the moment of the start of the pulse using the formula:

$$Tstart = AZ + \Delta T - PW/2,$$

where AZ is the moment of the actual zero crossing, $\Delta T$ is the expected duration of the half cycle in which the energizing pulse will be applied, and PW is the pulse width of the energizing pulse to be applied. In a digital implementation, each of these time values may be expressed as integer values representing the number of clock ticks of the oversampling clock (e.g. 32 MHz).
In **FIG. 9(f)** two different values for $\Delta T$ are used: $\Delta T1$ corresponding to the duration of a quarter of the cycle of the first resonance frequency fres1 higher than the carrier frequency, and $\Delta T2$ corresponding to a quarter of the cycle of the second resonance frequency fres2 lower than the carrier frequency, but the invention would also work if a single value for $\Delta T$ would be used, set equal to for example $\Delta T1$ or $\Delta T2$ or $(\Delta T1 + \Delta T2)/2$, or set to a quarter of the time of the ideal waveform at the predefined carrier frequency. Taking into account the real $\Delta T1$ and real $\Delta T2$ (e.g. based on previous measurements), can take into account the presence of metal, and is more accurate in the sense that the maximum of the current peak will coincide with the minimum of the voltage waveform, but is also more complex to implement. Using a fixed value for $\Delta T$ corresponding to the ideal waveform (without taking into account the real situation) is of course easier to implement. The skilled person can make a trade-off based on for example complexity versus energy efficiency. It is noted however that, if the ratio of C2 over C1 is relatively small (e.g. smaller than 25%), the difference between $\Delta T1$ and $\Delta T2$ will also be relatively small, and will probably not have a significant impact on the driver efficiency.

DAMPING PULSES:

In FIG. 9 the moments at which energizing pulses are to be injected are thus based on the detection of a zero-crossing moment and a delay (e.g. AT), and although not explicitly mentioned above, also the selection of those zero-crossings for which the slope of the antenna voltage Vantenna is negative or any other suitable criterium, because the energizing pulses for maintaining the oscillation are to be injected at voltage minima.

As will be shown in FIG. 15, when damping the oscillation, the energizing pulses should be placed close to the voltage maxima rather than the voltage minima. A similar prediction technique for starting the damping pulse can be used, but in this case the zero-crossing moments for which the slope of the antenna voltage Vantenna is positive are to be selected, or any other suitable criterium.

It is noted that, for active damping, actually one or both of the following techniques can be applied: (a) injecting pulses at the same moments as shown in FIG. 9(f), but the pulses having opposite sign, (b) injecting pulses with the same sign as shown in FIG. 9(f) but 180° phase shifted. However, inserting pulses with inverted sign requires a more complex current pulse generator (e.g. requires the use of PMOS transistors requiring more space than NMOS transistors when implemented in CMOS technology), hence the technique (b) is preferred.

SYSTEM CLOCK:

As can be understood from FIG. 9, the phase and thus but the frequency of the waveform generated by the resonant antenna circuit is mainly determined by timing information, and is relatively insensitive to tolerances or variations of the component values due to ageing or temperature etc. (see also FIG. 18 to FIG. 21). This is an important advantage of the present invention over some prior art solutions.

The accuracy of the transmitter device according to embodiments of the present invention is thus mainly dependent on the accuracy of the system clock (e.g. the 32 MHz clock mentioned above). Depending on the requirements of the receiver, the skilled person can use for example a local RC resonator, or a local crystal or an external crystal module for generating the system clock. A trimmed RC resonator has an estimated accuracy of about 1%, whereas a crystal oscillator can have an accuracy as small as of +/- 100 ppm (from its nominal value) or even as small as +/- 50 ppm or even lower.

For the envisioned applications, the carrier frequency is in the order of 10 kHz to 250 kHz, and the frequency of the crystal is typically in the order of 10 MHz to 40 MHz, hence the ratio of the local clock frequency and the oscillating antenna frequency is typically a value in the range from 40 to 4000, e.g. in the range from 100 to 1000, and is preferably chosen to be a power of two, for example equal to 128, 256 or 512, although that is not absolutely required.

METHOD OF TUNING:

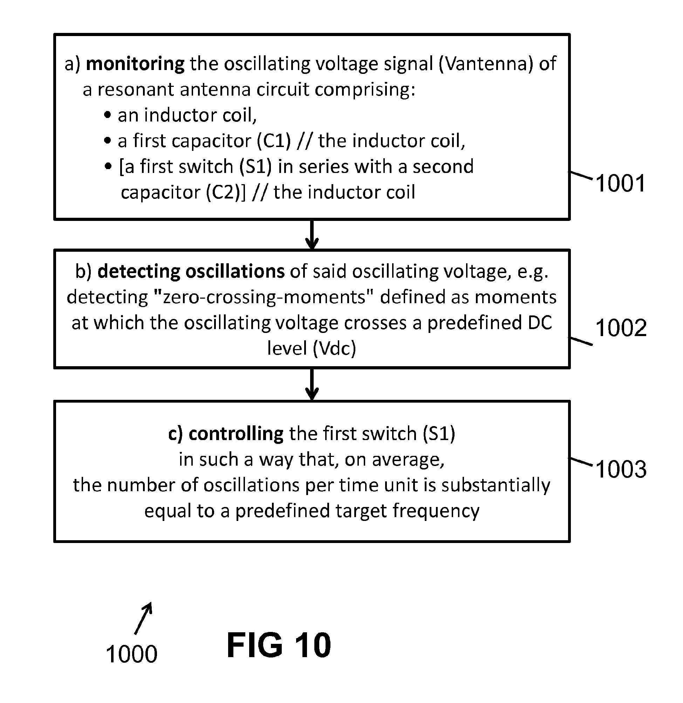

Referring to the block-diagram of FIG. 7, **FIG. 10** shows a method of tuning an oscillating voltage signal Vantenna generated by a resonant antenna circuit 701, where the antenna circuit comprises: an inductor coil 331, and a first capacitor C1 in parallel with the inductor coil, and (a first switch S1 in series with a second capacitor C2) in parallel with the inductor coil. The method comprises the steps of:

a) monitoring 1001 the oscillating voltage signal Vosc or Vantenna of the resonant antenna circuit;
b) detecting 1002 oscillations of the oscillating voltage, for example by detecting so called "zero-crossing-moments", defined as moment at which the oscillating voltage Vosc over the inductor coil crosses 0V, or the oscillating voltage Vantenna crosses a predefined DC level Vdc;
c) controlling 1003 the first switch S1 in such a way that, on average, the number of oscillations per time unit is substantially equal to a predefined target frequency.

In preferred embodiments, step c) comprises: selectively opening and closing the first switch S1 only at each said zero-crossing moment, and leaving the switch S1 open or closed between such zero-crossing moments.

In preferred embodiments, the first switch S1 is opened or closed at the resolution of half cycles, in contrast to full cycles in some prior art documents. For a given clock frequency of the oversampling clock, this allows more accurate tuning.

METHOD OF ENERGIZING:

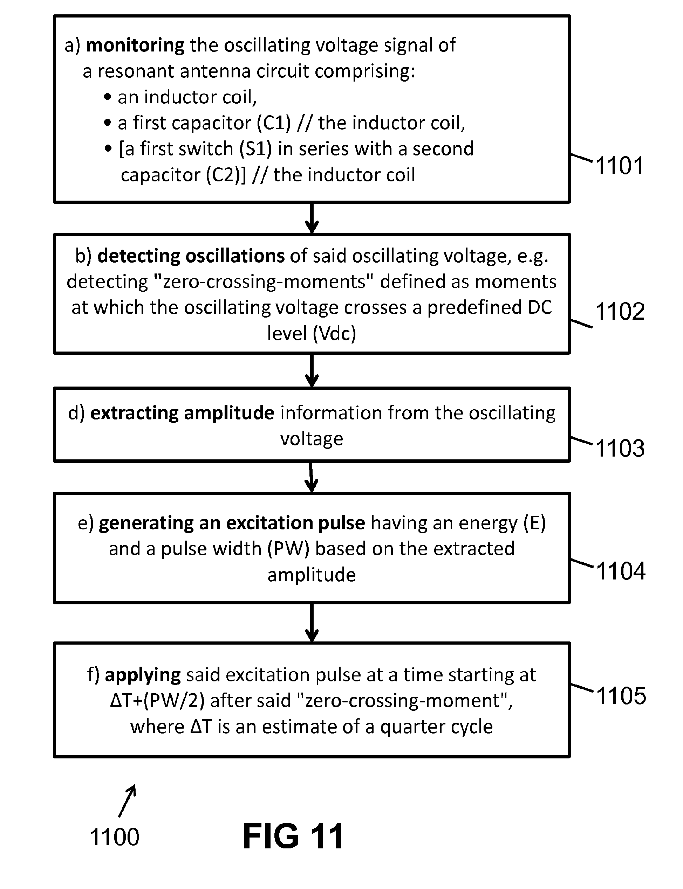

Referring to the block-diagram of FIG. 7, **FIG. 11** shows a method of energizing a resonant antenna circuit 701 comprising: an inductor coil 731, and a first capacitor C1 in parallel with the inductor coil, and (a first switch **S1** in series with a second capacitor C2) in parallel with the inductor coil. The method comprises the steps of:

a) monitoring **1101** the oscillating voltage signal Vosc or Vantenna of the resonant antenna circuit;
b) detecting **1002** oscillations of the oscillating voltage, for example by detecting so called "zero-crossing-moments", defined as moment at which the oscillating voltage Vosc over the inductor coil crosses 0V, or the oscillating voltage Vantenna crosses a predefined DC level Vdc;
d) extracting 1103 amplitude information from the oscillating voltage Vosc or Vantenna;
e) generating 1104 an excitation pulse having an amount of energy E and a pulse width PW based on the extracted amplitude;
f) applying 1105 said excitation pulse at a time starting at a delay=$\Delta T$+(PW/2) after said "crossing-moment", where $\Delta T$ is an estimate of a quarter cycle.

As described above when discussing FIG. 9(f), the time $\Delta T$ can be a fixed predefined time period based on the ideal waveform, or can be chosen taking into account whether the first switch S1 is closed or not, and/or taking into account past measurements of said period (assuming that the environment has not substantially changed since that measurement).

MODULATED WAVEFORM

**FIG. 12** shows a high level block diagram of a transmitter device 1200 and driver circuit 1210 according to an embodiment of the present invention, which can be seen as a variant of the transmitter device 200 and driver circuit 210 of FIG. 2.

While in the embodiment of FIG. 2 the time required for START and STOP was not important for the application (sending a carrier waveform), a fast START and a fast STOP is important when sending a modulated waveform, as is possible with the device and circuit of FIG. 12.

In addition to the blocks and functionality described above, the driver circuit 1210 further comprises an active damper circuit 1204, which according to aspects of the present invention is implemented by injecting anti-phase current pulses to the antenna circuit. The device and circuit of FIG. 12 also has an input port for receiving a binary bit-stream, for example originating from a UART of an external processor.

The control circuit 1203 is further adapted for fast changing from the mode OFF via START to ON, and for fast changing from mode ON via STOP to OFF, depending on the values of the bitstream to be transmitted. Preferably the duration of the START and STOP is as short as possible.

More specifically, in embodiments of the present invention, the "START" takes less than 10.0 x Pideal, which is the period of the ideal waveform (see FIG. 9a), for example less than 8.0 times Pideal, or less than 6.0 times Pideal, or less than 4.0 x Pideal, e.g. less than 3.0 x Pideal, e.g. less than 2.0 x Pideal, meaning that after this time the amplitude of the oscillating voltage Vosc is increased from about zero to higher than 90% of its nominal value.

Likewise, in embodiments of the present invention, the "STOP" takes less than 10.0 x Pdieal, for example less than 8.0 times Pideal, or less than 6.0 times Pideal, or less than 4.0 x Pideal, e.g. less than 3.0 x Pideal, e.g. less than 2.0 x Pideal, meaning that after this time the amplitude of the oscillating voltage Vosc is decreased from its nominal value to less than 10% of its nominal value.

**FIG. 13** illustrates by way of an example (but the number of oscillations shown is much smaller than the number used in reality), how the driver circuit 1210 of FIG. 12 can be used for transmitting an OOK-modulated signal (On-Off-Keying) as can be used for example in "Passive Entry applications". The binary bitstream is typically provided by a microcontroller having a "UART", but the invention is not limited thereto, and the bitstream can also be provided in other ways, such as for example by a microcontroller using timer interrupts, or by programmable hardware or a state-machine running at a predefined clock, but this is not the main focus of the present invention.

In the example of FIG. 13, while the value of the binary bitstream is '1', the driver circuit is in mode "ON" (i.e. actively oscillating) and maintaining the amplitude of the oscillating waveform at a nominal value. At a falling edge of the binary bitstream, or actually an appropriate moment shortly thereafter, the driver circuit quickly stops the oscillations of the resonant antenna circuit, by going from mode "ON" via mode "STOP" (i.e. decreasing the amplitude of the oscillations) to mode "OFF" (i.e. not sending energizing pulses to keep the amplitude substantially zero). As long as the value of the binary bitstream is '0', the driver circuit is in mode "OFF" and may optionally suppress oscillations of the resonant antenna circuit in any suitable way, for example by means of a switch in series with a resistance (not shown). At the rising edge of the binary bitstream (i.e. at a '0' to '1' transition), or actually at an appropriate moment shortly thereafter, the driver circuit quickly starts the oscillations of the resonant antenna circuit (i.e. increases the amplitude of the oscillating waveform) and then goes to mode "ON" for maintaining the amplitude at its nominal level.

**FIG. 14** shows a set of exemplary waveforms to illustrate "fast start-up" of the resonant circuit 1201 of FIG. 12.

* for fast startup of the resonating circuit, the pulse width and/or pulse height (amplitude) of the current pulses is chosen relatively large (e.g. as predefined values) until the target voltage amplitude across the antenna has been reached. In the example shown, three current pulses are provided with a relatively large energy content, but in practice this number may be smaller than three or larger than three.

* to sustain the oscillation, the losses of the antenna circuit are compensated by a current pulse having a suitable pulse width and/or pulse height chosen such that the voltage amplitude across the antenna (also known as "voltage swing") remains substantially constant overtime.

In the example shown in FIG. 14, the amplitude of the current pulses for maintaining the oscillations after start-up is the same as the amplitude of the current pulses applied during start-up, and only the pulse width is different, but that is not absolutely required, and both the amplitude and the pulse width may be varied.

It is noted however that the start-up pulses are in phase with the normal energizing pulses for maintaining the oscillation. (at a distance close to of about Pideal).

**FIG.** 15 shows a set of exemplary waveforms to illustrate "active damping " of the resonant circuit 1201 of FIG. 12, by applying relatively wide current pulses at the voltage maxima.

In order to stop the oscillation, current pulses are injected at or close to the time instants at which the voltage across the antenna experiences a maximum until the voltage amplitude across the antenna has been reduced to a predefined level. As will be explained further (FIG. 23 and FIG. 24), the current pulses to stop the oscillation may be created by a second, dedicated current pulse generator 2330, or using the same current pulse generator 2306 as is used for maintaining the oscillations.

In the example shown, three current pulses are provided with a relatively large energy content, i.e. a relatively large amplitude and/or a relatively large pulse width. As can be seen, the "damping pulses" are 180° phase shifted with respect with the "normal pulses", and the damping pulses are applied only at specific moments, not immediately after the '1' to '0' transition, but shortly after.

As can be understood from FIG. 14 and FIG. 15, the transmission device 1200 of FIG. 12 can be used for continuous-wave (CW) transmission, or for sending OOK-modulated signals. In fact several modulation methods (e.g. ASK, PSK) can be realized by driver circuits according to embodiments of the present invention, by suitable generation of the current pulses (energizing pulses) and suitable control of the first switch S1 for opening/closing the second capacitor C2.

In all schemes, there is a fast startup phase, in which the current pulses are made wider (and/or higher) than the "normal pulses" which are needed to sustain the oscillation, until a predefined oscillation amplitude is reached. Then the pulse width (and/or height) is reduced to the normal one that is needed to sustain the oscillation (e.g. determined based on the measured amplitude).

To end the oscillation, an active damping scheme is used. The current pulses are shifted by 180 degree, so that they occur at the voltage maximum. Similar to the fast startup, the current pulses are made wider (and/or higher) than in steady state oscillation.

BPSK modulation can be realized in much the same way as ASK modulation. The amplitude is first reduced to zero by active damping, and then increased again by fast start up to the full amplitude with a 180° phase shift. In a similar fashion, higher order PSK modulated signals can be created.

It is contemplated that bitrates of about 2 kbps (kilobits per second), or about 4 kbps or about 8 kbps should be feasible.

Looking back, FIG. 12 to FIG. 15 illustrated how the resonant circuit can be used for transmission of a modulated bitstream, where the resonant circuit is repeatedly started and stopped, for example at each bit-transition (see FIG. 13). This has the disadvantage that energy is lost for starting and stopping the oscillation.

**FIG. 16(a)** shows another solution, using the antenna-circuit of **FIG. 5(a).** The driver circuit 1610 works much in the same way as that of FIG. 2, including the first start-up of the device, but instead of actively stopping and re-starting the resonant antenna circuit as illustrated in FIG. 14 and FIG. 15, the transmitter device 1600 of FIG. 16 simply opens and closes the switch SF for temporarily freezing the oscillations. Of course, while freezing, no energizing pulses are applied to the resonant antenna circuit, and the switch S1 does not need to be controlled.

Data modulation using the transmitter device 1600 of FIG. 16, works as follows: during continuous transmission, the switch SF is always closed. During data-transmission, after a '1' to '0' transition, the control circuit 1603 waits for a moment at which the antenna voltage reaches a local minimum or maximum (which is also the moment at which the antenna current is zero), and then opens the switch SF. After a '0' to '1' transition of the incoming bitstream, the control circuit 1603 would wait until a next suitable moment, for example a moment at which the ideal voltage waveform has a local minimum or maximum, and then closes the switch SF. In case the phase of the oscillation has to change, the switch SF is simply kept open for an additional half of the ideal period (180° phase shift). For simplicity, during the first oscillation after restart, the energizing pulse may be skipped. The first switch S1 can be open or closed at restart.

As already indicated above, it is not immediately clear whether the transmitter device 1200 of FIG. 12 or the transmitter device 1600 of FIG. 16 is better than the other. For example, in terms of energy efficiency, it is not immediately clear whether the extra energy for the start-up-pulses and the damping pulses is smaller or larger than the energy losses through the switch SF which has to conduct most of the antenna current most of the time (also when no data is transmitted). In terms of pin-count and component cost, the solution of FIG. 12 is advantageous in that it requires less pins and does not require the switch SF. In terms of EMC behaviour and/or maximum bitrate, both solutions are believed to be equivalent, provided that the start- and stop-pulses are applied at suitable moments (see FIG. 14 and FIG. 15) and that the start and stop is sufficiently fast (e.g. requires at most 3x Pideal).

**FIG. 16(b)** shows a block-diagram of a system 1650 with a driver circuit 1660 as a variant of the system 1600 of FIG. 16(b), using the resonant antenna circuit of FIG. 5(b), adapted for temporarily freezing the oscillation only during data transmission.

In one embodiment, this driver circuit works in much the same way as that of FIG. 16(a), meaning that the driver circuit would operate the switches such that the resonance circuit has a first resonance frequency when the current flows through L and C1 (SF closed, S1 open) and has a second resonance frequency when the current flows through L and C1 in parallel with C2 (SF closed and S1 closed), but in addition, the oscillation could be stopped when both switches S1 and SF are simultaneously open.

In another embodiment having the same block-diagram as that of FIG. 16(b), but using another driver scheme, the driver circuit would operate the switches SF and S1 such that the resonance circuit has a first resonance frequency when the current flows through L and C1 but not through C2 (SF closed and S1 open), and has a second resonance frequency when the current flows through L and C2 but not through C1 (SF closed and S1 closed. The driver circuit could be adapted to operate only in one of these two modes, or could be adapted to furthermore operate the antenna circuit in a third mode wherein both switches SF and S1 are simultaneously open. The third mode would only be used during data transmission, for example for transmitting a BPSK or OOK modulated signal.

FREQUENCY SPECTRUM

FIG. 17 was already described above. It shows an example of an energizing pulse.

When this energizing pulse is applied periodically, at multiple integers of Pideal, as shown in FIG. 9(f), the spectrum of **FIG. 18** is obtained (illustrated on dual logarithmic scale). The reason for including this plot is to give an impression of the influence of the energizing pulses on the spectrum. It is noted however, that in FIG. 9(f) the energy pulses are not applied exactly at multiples of Pideal, but there is some jitter, because the energy pulses are applied at the moment when the actual antenna voltage reaches a minimum, for energy efficiency reasons.

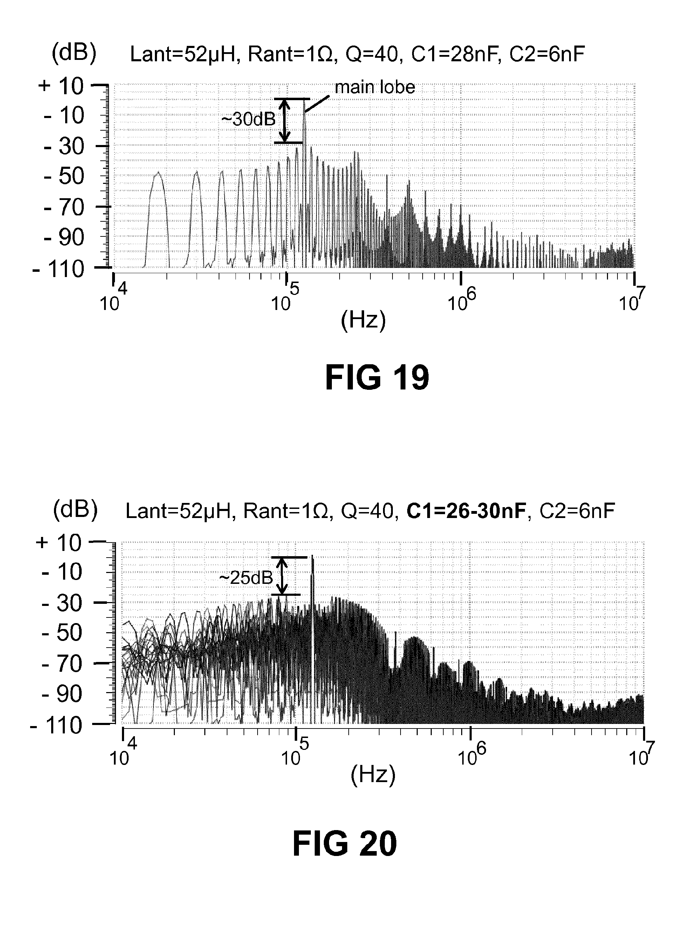

FIG. 19 shows an example of a frequency spectrum of the oscillating voltage obtainable with the transmission device and driver circuit of FIG. 7, using the "early-late" algorithm, for a continuous waveform, with Lantenna=$52\mu$H, Rantenna=$1\Omega$, Q=40, C1=28nF, C2=6nF, clk=32MHz. As can be seen, the difference between the top of the main lobe and the top of the second harmonics is about 30 dB, which is more than adequate for easy reception by most existing keys.

As described above, the exact position of the main lobe depends mainly on the accuracy of the "master clock" (also referred to as oversampling clock above).

Surprisingly, there is only one main lobe, instead of two peaks, despite the fact that the resonance circuit has two resonance frequencies, the first resonance frequency

fres1=1/(2*pi*sqrt(Lant*C1))=131.898 kHz and the second resonance frequency

fres2=1/(2*pi*sqrt(Lant*(C1+C2)))=119.696 kHz

In the example above, the values of C1 and C2 are chosen such that the first and second resonance frequency are located substantially symmetric around the carrier frequency (125 kHz), but that is not absolutely required. Further in the example, the ratio of C2/C1 is 6/28=21%, but other ratios can also be used. For example, the following combinations would all work:

(a) L=$52\mu$H, C1=29nF, C2=4nF, yielding a narrow band, (not much room for tuning),
(b) L=$52\mu$H, C1=28nF, C2=6nF, yielding a slightly broader band, (some room for tuning),
(c) L=$52\mu$H, C1=26nF, C2=10nF, yielding a broader band, (quite some room for tuning). but the present invention is not limited to these examples.

For completeness it is mentioned that the apparent "width" of the main lobe shown in the Figures depends on simulation or measurement settings, e.g. on the particular windowing function being used, and the number of samples used for the FFT, but in practice is a very sharp peak. In all spectrum plots shown herein, a time of 1 ms is used, and a "Blackman window".

**FIG. 20 to FIG. 22** illustrate that the spectrum of the generated waveform is indeed mainly dependent on the clock signal, and not substantially on the component values of the resonant circuit.

FIG. 20 shows in a single drawing several frequency spectra like that of FIG. 19, obtained by simulation using the parameters: Lant=$52\mu$H, Rant=$1\Omega$, Q=40, C1=26-30nF, C2=6nF, thus all parameters being the same as in FIG. 19, except for C1 which is swept from 26 nF to 30 nF. As can be seen, the main lobe looks pretty much the same as in FIG. 19, and the side lobes are at least 25 dB lower than the main lobe.

FIG. 21 shows in a single drawing several frequency spectra like that of FIG. 19, obtained by simulation using the parameters: Lant=$52\mu$H, Rant=$1\Omega$, Q=40, C1=28nF, C2=4-8nF, thus all parameters being the same as in FIG. 19, except for C2 which is swept from 4 nF to 8 nF. As can be seen, the main lobe looks pretty much the same as in FIG. 19, and the side lobes are at least 28 dB lower than the main lobe.

FIG. 22 shows in a single drawing several frequency spectra like that of FIG. 19, obtained by simulation using the parameters: Lant=48-57$\mu$H, Rant=$1\Omega$, Q=40, C1=28nF, C2=4-8nF, thus all parameters being the same as in FIG. 19, except for Lant which is swept from 48 $\mu$H to 57 $\mu$H. As can be seen, the main lobe looks pretty much the same as in FIG. 19, and the side lobes are at least 25 dB lower than the main lobe.

ACTIVE DAMPING WITH SECOND CURRENT GENERATOR

In FIG. 12 a transmitter device 1200 with an active damping circuit 1204 was shown. In a simple solution, the active damping can be implemented using the same (single) current pulse generator that was also used for injecting the energizing pulses when starting or maintaining the continuous oscillation (see block 706 of FIG. 7 for example).

**FIG. 23** shows a block-diagram of a transmitter device 2300 (or rather a portion thereof), comprising a first current pulse generator 2306 adapted for providing the energizing pulses during start-up and when maintaining continuous oscillations, but further comprising a second current pulse generator 2330 dedicated to active damping. The second current pulse generator is connected between node Na2 of the antenna and the supply voltage Vdc, while the first current pulse generator is connected between node Na1 of the resonant antenna circuit and ground.

This offers the following advantages, as can be appreciated from the exemplary waveforms shown in **FIG. 24:**

- less voltage drop across the driver circuit, lower dissipation in the driver, improved lifetime,
- during damping, no additional power is drawn from the power supply since the damping current "Ipulse2" does not flow through the power supply.

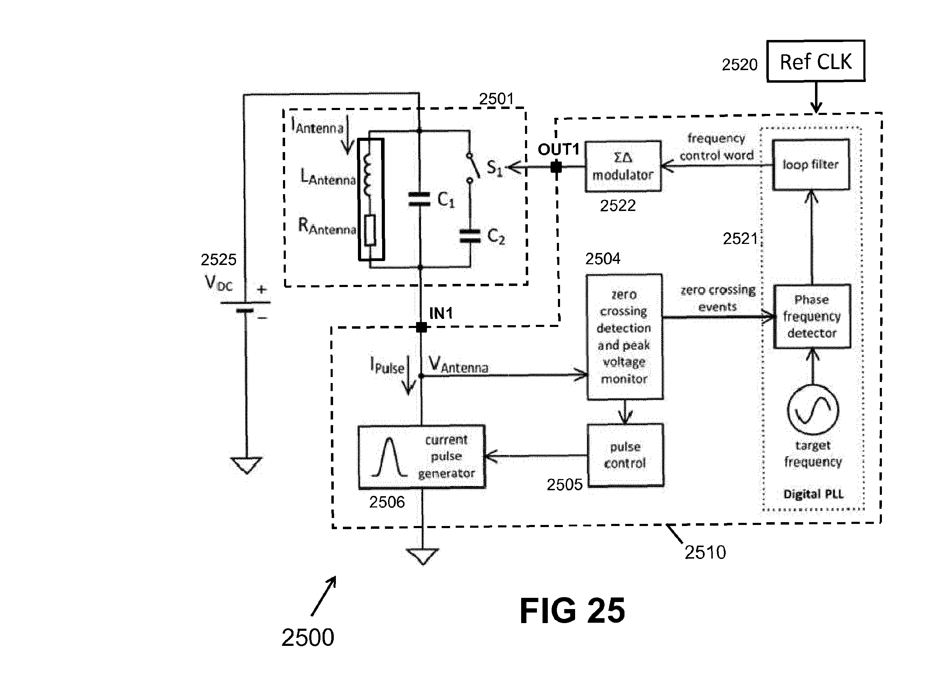

**FIG. 25** shows another detailed block diagram of a driver circuit and a transmitter device according to an embodiment of the present invention. This driver circuit can be seen as a variant of the driver circuit of FIG. 7, wherein the "early-late detection mechanism" is replaced by another mechanism based on "a digital PLL and a sigma-delta modulator". The driver circuit of FIG. 25 is configured for performing a somewhat more complex tuning algorithm than the "early-late algorithm".

The digital PLL and sigma delta modulator provide a second scheme for the control of the resonant frequency to be substantially equal to the predefined carrier frequency. In this embodiment, the first switch S1 is controlled by a digital sigma-delta modulator, which converts a high-resolution frequency control word into a bit stream that is used to control the first switch S1. In combination with the Sigma-Delta-Modulator, the resonant antenna driver circuit 2510 can be perceived as a digitally tunable VCO. A digital PLL is used to adjust the frequency control word in a way that the average resonant frequency is equal to the target frequency.

In contrast to the first scheme (based on early-late detection), this second scheme (based on sigma-delta modulator) allows for higher-order quantization noise shaping by using a higher-order sigma-delta modulator, resulting in a higher spectral purity close to the carrier frequency. A high spectral purity is advantageous e.g. for receiving backscattered signals from passive transponders. A potential disadvantage is the limited bandwidth of the PLL loop, which may result in slower settling to the target frequency.

Everything else described above in relation to FIG. 7 is also applicable here. For example, the driver circuit 2510 may be implemented as an integrated circuit, which may optionally further comprise a DC/DC convertor and/or a clock generator.

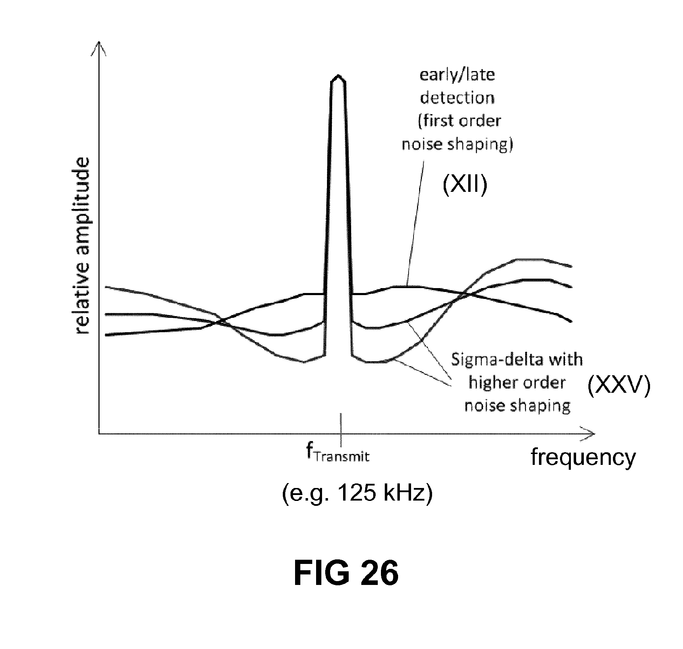

**FIG. 26** shows a qualitative graph to illustrate the effect of using the sigma-delta modulator of FIG. 25 instead of the earl-late detector of FIG. 7. Although not yet confirmed by measurements, the following effects are expected: (a) the noise floor (level of the spurious peaks) close to the transmit frequency (distance about 10...20% of transmit frequency) will decrease; (b) the noise floor further away from the transmit frequency will increase; (c) harmonics are substantially unaffected.

These changes are beneficial if the driver is used for communication with a passive transponder that is answering via load modulation/back-scattering on top of the transmit signal. In such applications, it is advantageous to have a low noise floor close to the transmit frequency, so that the small modulation sidebands of the answer from the passive transponder can be recognized. The increased noise floor further away from the transmit frequency can be tolerated because the driver amplitude in this specific application is low compared to the maximum possible driver amplitude.

MULTIPLE ANTENNAS

As already suggested above, driver circuits according to the present invention may be adapted for simultaneously driving a plurality of resonant antenna circuits from a single integrated device. The plurality of antenna circuits, for example at least 2, or at least 3, or at least 4 or at least 5 or at least 6 antenna circuits, may be mounted for example at different locations of a car.

When simultaneously driving a plurality of resonant antenna circuits of the kind shown in FIG. 3, for example three antenna circuits, the driver circuit only requires 3 interface pins for driving the antenna circuits, because one node of each antenna circuit can be connected to the (common) supply voltage, and the other node of each antenna circuit needs to be monitored and driven in a manner as described above. Of course other pins are also required, e.g. for connection to an external crystal (typically 2 pins), and for connection to Ground and a supply voltage (at least 2 pins).

Importantly, the driver circuit would typically comprise multiple control circuits and multiple energizing circuits, but they would use a single common clock signal or a single common ideal waveform as shown in FIG. 9(a) or another equivalent synchronization mechanism. As described above, since each individual antenna signal is synchronized to the ideal waveform, it is also guaranteed that the waveforms of the plurality of antenna circuits running substantially in-phase, with only a small phase difference. In this way the risk of destructive interference is drastically reduced or even eliminated.

NUMBER OF PINS:

When simultaneously driving a plurality (for example N=3) of resonant antenna circuits of the kind shown in FIG. 3, the driver circuit needs one input pin for sensing/monitoring the antenna voltage "Vantenna", and one output pin for providing the control signal for opening/closing the switch.

It is possible to use external power MOS devices (for example transistors) as switch. However, as the switch needs to operate for both polarities, typically two anti-serial devices are used, which would require different gate control signals, thus two pins for each switch rather than one.

If the antenna circuit also comprises a freeze switch SF, as shown for example in FIG. 5(a) and FIG. 5(b), then an additional output pin is required (for each antenna circuit) for controlling the freeze-switch SF. But it is contemplated that the freeze-signal could be shared between the plurality of antenna circuits, in order to save pins. It is noted in this respect that "freezing" the different oscillations may not occur exactly at the voltage minimum for each antenna circuit, but very close to this moment. Since the switch SF is only used during data communication, this may be acceptable for at least some applications.

If the driver circuit also provides the power and ground, then additional pins are needed.

OVERALL ENERGY EFFICIENCY:

When comparing the overall energy efficiency of a transmitter device using the resonant antenna circuit of FIG. 3 (without the switch SF) and the resonant antenna circuit of FIG. 4 (with the switch SF), the following is noted:

a) if the resonant antenna circuit is not transmitting data, but only transmits a continuous wave at the carrier wave, the circuit of FIG. 3 is more energy efficient than that of FIG. 5(a),(b), because the switch SF of FIG. 5(a),(b) causes resistive losses, as it has to conduct most of the antenna current (typically up to 10 Amps).

b) if the resonant antenna circuit is transmitting data in the form of a modulated waveform, then the antenna circuit of FIG. 3 needs to be frequently started and stopped (as explained in FIG. 12 to FIG. 15) by using start-pulses or stop-pulses, which require energy. In contrast, when using the antenna circuit of FIG. 5(a),(b) (see e.g. FIG. 16(a),(b) only the switch SF needs to be opened to temporarily freeze the oscillation.

Therefore, the circuit of FIG. 16(a),(b) can be more energy efficient during data transmission. However, it is only more energy efficient overall, if on average the losses of the switch SF are lower than the energy used to start and stop the oscillation.

It is explicitly pointed out that not all claimed embodiments of the present invention are explicitly shown in the figures, since most drawings are intended to illustrate only particular features. Other embodiments of the invention are recited by the claims, and their dependencies.

Finally, it is noted that several functions can be implemented in more than one way, for example:

- control of switch S1: for example using the "early-late" mechanism or using "sigma-delta-modulation", or using another mechanism that ensures that on average, the number of oscillations per time unit (for example per second, or another relatively large number of periods of the ideal frequency, for example at least 100 or at least 250 or at least 1000 such periods Pideal) is substantially equal to the predefined target frequency;
- data modulation by "start/stop" (see FIG. 14 and FIG. 15) or by "freezing" (FIG. 16);
- predicting the moment of providing energy pulses using Pideal, or using $\Delta T1$ and $\Delta T2$;

and while individual features are explained in different drawings and different embodiments of the present invention, it is contemplated that features of different embodiments can be combined, as would be obvious to the skilled person, when reading this document.

**Claims**

1. A driver circuit (210; 710; 1210; 1610; 1660; 2510) connectable to a resonant antenna circuit,

   - the resonant antenna circuit (201; 301; 501; 551; 601; 701; 1201; 1601; 1651; 2501) comprising three branches connected in parallel:

      * a first branch comprising an inductor coil (331; 531; 631; 731);
      * a second branch comprising a first capacitance (C1);
      * a third branch comprising a second capacitance (C2) connected in series with a first switch (S1);

         - and wherein the first capacitance (C1) is chosen such that the antenna circuit has a first resonance frequency (fres1) higher than a predefined target frequency (ftarget) if the first switch (S1) would be permanently open;
         - and wherein the second capacitance (C2) is chosen such that the antenna circuit has a second resonance frequency (fres2) lower than the target frequency (ftarget) if the first switch (S1) would be permanently closed;

- the driver circuit (210; 710; 1210; 1610; 2510) comprising:

- monitoring means adapted for monitoring the oscillating voltage signal (Vantenna);
- means for detecting oscillations of said oscillating voltage signal (Vantenna);
- a control circuit for dynamically controlling the first switch (S1) in such a way that, on average, the number of oscillations of the oscillating voltage (Vantenna) per time unit is substantially equal to the target frequency (ftarget).

2. A driver circuit according to claim 1, wherein the means for detecting oscillations of said oscillating voltage comprises means for detecting zero-crossing-moments defined as moments in time (AZ1, AZ2, AZ3) at which the oscillating voltage (Vantenna) crosses a fixed or variable DC level (Vdc); and wherein the control circuit is adapted for selectively opening and closing the first switch (S1) at said zero-crossing moments, and for keeping the first switch (S1) open or closed between said zero-crossing moments.

3. A driver circuit according to any of the previous claims, further comprising a clock generator adapted for generating a clock signal (CLK) having a frequency of at least 2.0 times the target frequency (ftarget); and wherein the monitoring means is adapted for detecting said zero-crossing-moment (AZ1, AZ2, AZ3) at the resolution of said clock signal (CLK).

4. A driver circuit according to any of the previous claims, wherein the control circuit is further adapted for determining if the zero-crossing moments (AZ1, AZ2, AZ3) occurred sooner or later than a reference moment (IZ1, IZ2, IZ3) at which the zero-crossing should occur if the resonant circuit was oscillating at the target frequency (ftarget), and

- in case it is determined that the zero-crossing-moment (AZ1,AZ2, AZ3) occurred sooner than the reference moment (IZ1, IZ2, IZ3), to provide a control signal for closing the first switch (S1),
- in case it is determined that the zero-crossing-moment (AZ1,AZ2, AZ3) occurred later than the reference moment (IZ1, IZ2, IZ3), to provide a control signal for opening the first switch (S1).

5. A driver circuit according to any of the claims 1 to 3, wherein the control circuit further comprises:

- a digital PLL (2521) adapted for receiving zero-crossing events, and adapted for generating a frequency control word; and
- a sigma-delta modulator (2522) adapted for receiving said frequency control word, and for providing said control signal for opening or closing the first switch (S1).

6. A driver circuit according to any of the previous claims,

- wherein the monitoring means is further adapted for measuring or extracting amplitude information of the oscillating antenna-voltage (Vantenna); and
- wherein the driver circuit further comprises an excitation circuit adapted for generating an excitation pulse based on said amplitude information, and adapted for applying said excitation pulse;

7. A driver circuit according to claim 6, wherein the excitation circuit is adapted for applying said excitation pulse at a moment in time corresponding to the zero-crossing-moment plus a delay, wherein the delay is substantially equal to $\Delta T+(PW/2)$, where $\Delta T$ is substantially equal to $1/(4 \times ftarget)$, and PW is a pulse with of the excitation pulse, or wherein the delay is substantially equal to $(\Delta T1)+(PW/2)$, where $\Delta T1$ is substantially equal to $1/(4 \times fres1)$, and PW is a pulse with of the excitation pulse, or wherein the delay is substantially equal to $(\Delta T2)+(PW/2)$, where $\Delta T2$ is substantially equal to $1/(4 \times fres2)$, and PW is a pulse with of the excitation pulse.

8. A driver circuit according to claim 6 or 7, wherein the excitation circuit comprises a digitally controllable current source or a digitally controllable current limiter.

9. A driver circuit according to any of the previous claims, further comprising a damping circuit (1204; 2330) adapted for actively damping the oscillating voltage signal (Vantenna).

10. A driver circuit according to claim 9, wherein the driver circuit further comprises an input port adapted for receiving a binary input signal; and wherein the control circuit is further adapted for starting and stopping the oscillating waveform based on said binary input signal, thereby transmitting a modulated signal.

**11.** A driver circuit (1610) according to any of the previous claims, connectable to said resonant antenna circuit (1601),

- wherein said resonant antenna circuit (1601) furthermore comprising a second switch (SF) in series with the inductor coil in its first branch; and
- wherein the driver circuit further comprises an input port adapted for receiving a binary input signal; and
- wherein the control circuit is furthermore adapted for selectively opening and closing said second switch (SF) only when transmitting a modulated signal, and for keeping the second switch (SF) closed otherwise.

**12.** A transmitter circuit (200; 700; 1200; 1600; 2500) for transmitting an electromagnetic signal in a predefined frequency range comprising a predefined target frequency (ftarget), the transmitter circuit comprising:

- a resonant antenna circuit (201; 301; 501; 601; 701; 1201; 1601; 2501) as specified in any of the previous claims;
- a driver circuit (210; 710; 1210; 1610; 2510) as specified in any of the previous claims, operatively connected to said resonant antenna circuit.

**13.** A method of driving a resonant antenna circuit for generating an oscillating voltage signal (Vantenna) at a predefined target frequency (ftarget), the resonant antenna circuit comprising three branches connected in parallel, including:

* a first branch comprising an inductor coil;
* a second branch comprising a first capacitance (C1);
* a third branch comprising a second capacitance (C2) connected in series with a first switch (S1);

- and wherein the first capacitance (C1) is chosen such that the antenna circuit has a first resonance frequency (fres1) higher than the target frequency (ftarget) if the first switch (S1) would be permanently open;
- wherein the second capacitance (C2) is chosen such that the antenna circuit has a second resonance frequency (fres2) lower than the target frequency (ftarget) if the first switch (S1) would be permanently closed; the method comprises the steps of:

a) monitoring (1001) the oscillating voltage signal (Vantenna) of the resonant antenna circuit;

b) detecting oscillations of said oscillating voltage signal (Vantenna);

c) dynamically controlling (1003) the first switch (S1) in such a way that, on average, the number of oscillations of the oscillating voltage (Vantenna) per time unit is substantially equal to the target frequency (ftarget).

**14.** A method according to claim 13, wherein step b) comprises detecting zero-crossing-moments defined as moments in time (AZ1, AZ2, AZ3) at which the oscillating voltage (Vantenna) crosses a fixed or variable DC level (Vdc); and wherein step c) comprising selectively opening and closing the first switch (S1) at said zero-crossing moments (AZ1, AZ2, AZ3), and for keeping the first switch (S1) open or closed between said zero-crossing moments.

**15.** A method of transmitting an electromagnetic signal in a predefined frequency range comprising a predefined target frequency (ftarget), the method comprising:

- a method of driving a resonant antenna circuit according to claim 13 or 14;
- a method of energizing said resonant antenna circuit, comprising the steps of:

d) extracting (1103) amplitude information from the oscillating voltage (Vantenna);

e) generating (1104) excitation pulses for maintaining the oscillating voltage (Vantenna);

f) applying (1105) said excitation pulses at a delay after said "zero-crossing-moment", wherein the delay is substantially equal to $\Delta T+(PW/2)$, where $\Delta T$ is substantially equal to $1/(4 \times ftarget)$, and PW is a pulse with of the excitation pulse, or wherein the delay is substantially equal to $(\Delta T1)+(PW/2)$, where $\Delta T1$ is substantially equal to $1/(4 \times fres1)$, and PW is a pulse with of the excitation pulse, or wherein the delay is substantially equal to $(\Delta T2)+(PW/2)$, where $\Delta T2$ is substantially equal to $1/(4 \times fres2)$, and PW is a pulse with of the excitation pulse.

FIG 1 (prior art)

EP 3 316 182 A1

carrier frequency

**FIG 2**

201

Na1        resonant antenna circuit        Na2

Vosc

**P1**                      **P2**

213

excitation
202   circuit

control
203   circuit

210

220   timing unit

200

**FIG 3**

Na1

331

$L_{Antenna}$

$R_{Antenna}$

$C_1$

$S_1$    select

$C_2$

301

Na2

25

**FIG 4**

FIG 5(a)

FIG 5(b)

FIG 6

FIG 7

**FIG 8**

**FIG 9**

a) **monitoring** the oscillating voltage signal (Vantenna) of
a resonant antenna circuit comprising:
- an inductor coil,
- a first capacitor (C1) // the inductor coil,
- [a first switch (S1) in series with a second
  capacitor (C2)] // the inductor coil

1001

b) **detecting oscillations** of said oscillating voltage, e.g.
detecting "zero-crossing-moments" defined as moments
at which the oscillating voltage crosses a predefined DC
level (Vdc)

1002

c) **controlling** the first switch (S1)
in such a way that, on average,
the number of oscillations per time unit is substantially
equal to a predefined target frequency

1003

1000

**FIG 10**

a) **monitoring** the oscillating voltage signal of
a resonant antenna circuit comprising:
- an inductor coil,
- a first capacitor (C1) // the inductor coil,
- [a first switch (S1) in series with a second
  capacitor (C2)] // the inductor coil

1101

b) **detecting oscillations** of said oscillating voltage, e.g.
detecting "zero-crossing-moments" defined as moments
at which the oscillating voltage crosses a predefined DC
level (Vdc)

1102

d) **extracting amplitude** information from the oscillating
voltage

1103

e) **generating an excitation pulse** having an energy (E)
and a pulse width (PW) based on the extracted
amplitude

1104

f) **applying** said excitation pulse at a time starting at
ΔT+(PW/2) after said "zero-crossing-moment",
where ΔT is an estimate of a quarter cycle

1105

1100

# FIG 11

modulated transmission

Na1   res. antenna   Na2
1201  circuit

Vosc

P1   P2

1213

1210

bitstream

damping
1204  circuit

excitation
1202  circuit

control
1203 circuit

timing unit
1220

1200

# FIG 12

'1'

'0'   binary bitstream

STOP  START

OOK modulated signal

ON   OFF   ON

# FIG 13

start-up pulses

# FIG 14

# FIG 15

damping pulses

modulated transmission

**FIG 16(a)**

modulated transmission

FIG 16(b)

**FIG 17**

**FIG 18**

**FIG 19**

**FIG 20**

(dB)   Lant=52μH, Rant=1Ω, Q=40, C1=28nF, **C2=4-8nF**

~28dB

**FIG 21**

(dB)   **Lant=48-57μH**, Rant=1Ω, Q=40, C1=28nF, C2=6nF

~25dB

**FIG 22**

**FIG 23**

2300

**FIG 24**

FIG 25

FIG 26

Europäisches
Patentamt

European
Patent Office

Office européen
des brevets

# EUROPEAN SEARCH REPORT

Application Number

EP 16 19 6132

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/231039 A1 (LOCKE GORDON EVAN [CA]) 18 December 2003 (2003-12-18) | 1-6,8-14 | INV. G06K19/07 |
| A | * paragraphs [0021], [0022], [0030] - paragraphs [0034], [0047] - [0050]; figures 2-4,6 * | 7,15 | |
| X | US 2006/113970 A1 (STOVER HOWARD H [US] ET AL) 1 June 2006 (2006-06-01) * paragraph [0026] - paragraph [0042]; figures 1,5 * | 1,13 | |
| X | US 2005/237198 A1 (WALDNER MICHELE A [US] ET AL) 27 October 2005 (2005-10-27) * paragraphs [0029], [0030]; figure 2 * | 1 | |
| X | WO 2016/041889 A1 (KONINKL PHILIPS NV [NL]) 24 March 2016 (2016-03-24) * the whole document * | 1 | |

TECHNICAL FIELDS
SEARCHED     (IPC)

G06K

The present search report has been drawn up for all claims

| Place of search | Date of completion of the search | Examiner |
|---|---|---|
| Munich | 24 April 2017 | Fichter, Uli |

EPO FORM 1503 03.82 (P04C01)

## ANNEX TO THE EUROPEAN SEARCH REPORT
## ON EUROPEAN PATENT APPLICATION NO.

EP 16 19 6132

This annex lists the patent family members relating to the patent documents cited in  the above-mentioned European search report.
The members are as contained in the European Patent Office EDP file on
The European Patent Office is in no way liable for these particulars which are merely given for the purpose of information.

24-04-2017

| Patent document cited in search report | | Publication date | Patent family member(s) | | Publication date |
|---|---|---|---|---|---|
| US 2003231039 | A1 | 18-12-2003 | CA | 2390845 A1 | 18-12-2003 |
|  |  |  | US | 2003231039 A1 | 18-12-2003 |
| US 2006113970 | A1 | 01-06-2006 | EP | 1666002 A1 | 07-06-2006 |
|  |  |  | US | 2006113970 A1 | 01-06-2006 |
| US 2005237198 | A1 | 27-10-2005 | AU | 2005236802 A1 | 03-11-2005 |
|  |  |  | BR | PI0509688 A | 09-10-2007 |
|  |  |  | CA | 2563279 A1 | 03-11-2005 |
|  |  |  | CN | 1965324 A | 16-05-2007 |
|  |  |  | EP | 1738301 A1 | 03-01-2007 |
|  |  |  | JP | 2007533204 A | 15-11-2007 |
|  |  |  | KR | 20070012462 A | 25-01-2007 |
|  |  |  | NZ | 550499 A | 28-03-2008 |
|  |  |  | SG | 132688 A1 | 28-06-2007 |
|  |  |  | TW | 200620132 A | 16-06-2006 |
|  |  |  | US | 2005237198 A1 | 27-10-2005 |
|  |  |  | US | 2007057797 A1 | 15-03-2007 |
|  |  |  | WO | 2005104022 A1 | 03-11-2005 |
| WO 2016041889 | A1 | 24-03-2016 | NONE | | |

EPO FORM P0459

For more details about this annex : see Official Journal of the European Patent Office, No. 12/82

**EP 3 316 182 A1**

**REFERENCES CITED IN THE DESCRIPTION**

**Patent documents cited in the description**

- US 2016250995 A1